# EUROPÄISCHE PATENTSCHRIFT

(11) **EP 2 986 093 B1**
(45) Veröffentlichungstag und Bekanntmachung des Hinweises auf die Patenterteilung: **28.06.2017**
(21) Anmeldenummer: 15179506.9
(22) Anmeldetag: 03.08.2015
(51) Int. Cl.: H05K 7/14

(54) **KOPPELEINHEIT UND INDUSTRIELLES STEUERUNGSSYSTEM**
COUPLING UNIT AND INDUSTRIAL CONTROL SYSTEM
COUPLEUR ET SYSTEME DE COMMANDE INDUSTRIEL

(30) Priorität: 04.08.2014 DE 102014111030
(43) Veröffentlichungstag der Anmeldung: 17.02.2016
(73) Patentinhaber: Beckhoff Automation GmbH, 33415 Verl (DE)
(72) Erfinder: Budde, Torsten, 33335 Gütersloh (DE); Jost, Michael, 32694 Dörentrup (DE)
(74) Vertreter: Patentanwaltskanzlei WILHELM & BECK

(56) Entgegenhaltungen:
- EP-A2- 2 227 072
- DE-A1-102006 031 129
- DE-A1-102007 050 943
- DE-C2- 3 740 290
- DE-U1-202010 006 065
- US-A1- 2004 206 613
- US-A1- 2013 173 868

## Beschreibung

Die vorliegende Erfindung betrifft eine Koppeleinheit für ein industrielles Steuerungssystem und ein industrielles Steuerungssystem.

In der Automatisierungstechnik werden industrielle Steuerungssysteme zur Anlagen-, Maschinen- und Prozesssteuerung verwendet, beispielsweise um Fertigungsprozesse oder Verpackungsprozesse zu steuern und zu überwachen. Ein industrielles Steuerungssystem weist im Allgemeinen eine Feldebene mit Feldgeräten und eine Steuerebene mit Steuergeräten auf. Als Feldgeräte werden bei der industriellen Prozessautomation unter anderem Aktoren, wie Antriebe oder Ventile, und Messwertgeber, wie Kodierer und Sensoren, eingesetzt.

Die Steuerebene umfasst unter anderem Geräte zur Programmierung, Steuerung, Überwachung und Visualisierung der auszuführenden Prozesse. Hier werden in der Regel speicherprogrammierbare Steuerungen (SPS) oder Steuerungsrechner, etwa Industrie-PCs, eingesetzt werden. Ein Steuerungsrechner kann beispielsweise als Prozessleitrechner in einer Fertigungsstraße verwendet werden.

Zur Kommunikation zwischen Steuerebene und Feldebene werden üblicherweise Feldbussysteme eingesetzt, die Kommunikationsdaten über ein Datennetzwerk übertragen. Bei den Kommunikationsdaten kann es sich unter anderem um Steuerbefehle zur Ansteuerung von Feldgeräten oder auch um Messdaten handeln. Die Messdaten können beispielsweise auf Messgrößen basieren, die zuvor von einem Feldgerät erfasst worden sind. Feldbussysteme setzen verschiedene Protokolle zur Datenübertragung ein. Ein mögliches Datenübertragungsprotokoll ist das EtherCAT-Protokoll, welches eine echtzeitfähige Kommunikation über ein Ethernet-Netzwerk ermöglicht und in der Norm IEC 61158 spezifiziert wird. Bei einer Datenübertragung nach dem EtherCAT-Standard werden Datentelegramme zur Übertragung der Kommunikationsdaten verwendet. Die Datentelegramme enthalten Steuerdaten, welche die Verteilung und Verarbeitung der Datentelegramme in dem Feldbussystem regeln, und Nutzdaten, welche unter anderem die Kommunikationsdaten umfassen.

Feldbussysteme können in verschiedenen Netzwerktopologien ausgeführt sein, welche die Anordnung der einzelnen Busteilnehmer innerhalb des Feldbussystems beschreiben. Bei einer Ringtopologie sind alle Busteilnehmer nacheinander in Reihe verbunden. Datenpakete mit den Kommunikationsdaten durchlaufen ausgehend von einem ersten Busteilnehmer der Reihe nach alle anderen Busteilnehmer, welche Kommunikationsdaten mit den Datenpaketen austauschen können. Anschließend werden die Datenpakete wieder an den ersten Busteilnehmer zurückgesendet. Eine Variante der Ringtopologie ist die Linientopologie, welche einen geöffneten Ring darstellt. Nachdem die Datenpakete alle Busteilnehmer der Reihe nach durchlaufen haben, werden die Datenpakete in umgekehrter Richtung über die Busteilnehmer an den ersten Busteilnehmer zurückgesendet. Der erste Busteilnehmer ist in der Regel ein Gerät der Steuerebene, etwa ein Steuerrechner.

Ein echtzeitfähiges Feldbussystem in Linientopologie kann mittels des EtherCAT-Standards realisiert werden, welcher in der Norm IEC 61158 beschrieben wird. Auf der Bitübertragungsschicht (*physical layer*) kann beim EtherCAT-Standard unter anderem der Ethernet-Standard oder der E-Busstandard, welcher auf Low-Voltage-Differential-Signaling (LVDS) basiert, eingesetzt werden. Bei LVDS handelt es sich um eine leiter- bzw. kabelgebundene Übertragungstechnik, welche differentielle Spannungspegel zur Datenübertragung nutzt und in der Norm ANSI/TIA/EIA-644-1995 spezifiziert ist. Die Datenübertragung basiert bei E-Bussystemen auf einem von einer Konstantstromquelle erzeugten Stromfluss durch eine zweiadrige Übertragungsleitung, wobei binäre Logikwerte durch die Stromflussrichtung repräsentiert werden. Die Impedanz der Übertragungsleitung beträgt in der Regel etwa 100-120 Ohm. Mittels LVDS können Datenraten von mehreren 100 MBit/s oder einigen GBit/s realisiert werden. Zur Datenübertragung der Kommunikationsdaten werden bei einem E-Bussystem Datentelegramme eingesetzt, welche die EtherCAT-Datentelegramme verkapseln.

Die unterschiedlichen, zur Prozesssteuerung eingesetzten Feldgeräte wie Antriebe oder Sensoren verfügen in der Regel nicht über eine eigene, integrierte Schnittstelle zum Feldbus. Sie werden damit nicht direkt über die digitalen Kommunikationsdaten angesteuert, sondern senden oder empfangen digitale oder analoge Feldsignale. Bei den Feldsignalen kann es sich beispielsweise um analoge oder digitale Spannungspegel handeln. Entsprechend verfügen die einzelnen Feldgeräte in der Regel über einen oder mehrere digitale oder analoge Ein- und Ausgänge. Sind die Feldgeräte als Motoren oder Antriebe ausgebildet, können diese auch über geregelte Ströme angesteuert werden, die unter Umständen auch hohe Antriebsleistungen übertragen können.

Zur Umsetzung der Kommunikationsdaten in die Feldsignale werden in der Regel Steuerungsmodule eingesetzt. Die Steuerungsmodule sind sowohl über das Feldbussystem mit den Geräten der Steuerebene verbunden, als auch über Feldsignalleitungen mit den Feldgeräten. Die Steuerungsmodule können als digitale oder analoge Eingangsmodule bzw. als digitale oder analoge Ausgangsmodule ausgebildet sein.

Handelt es sich um Ausgangsmodule, so empfangen die Steuerungsmodule Steuerbefehle von den Geräten der Steuerebene als Kommunikationsdaten über das Feldbussystem. Die Ausgangsmodule erzeugen auf Grundlage der Steuerbefehle ausgehende Feldsignale, welche unter anderem aus analogen oder digitalen Spannungssignalen oder geregelten Strömen bestehen können. Die Feldsignale werden über Ausgangsanschlüsse der Steuerungsmodule ausgegeben. Die ausgehenden Feldsignale werden anschließend über die Feldsignalleitungen an die Feldgeräte übertragen. Die ausgehenden Feldsignale können unter anderem der Ansteuerung von Antrieben, Motoren oder Ventilen dienen.

Handelt es sich bei den Steuerungsmodulen um Eingangsmodule, so empfängt das Steuerungsmodul eingehende Feldsignale, welche unter anderem aus analogen oder digitalen Spannungs- oder Stromsignalen bestehen können. Das Eingangsmodul wandelt die Feldsignale in Kommunikationsdaten um, welche etwa gemessene Spannungs- oder Stromwerte repräsentieren können. Anschließend kann das Steuerungsmodul die Kommunikationsdaten über das Feldbussystem an die Geräte der Steuerebene, beispielsweise an einen Steuerungsrechner, übertragen.

Die Steuerungsmodule stellen typischerweise mehrere Anschlüsse für die Feldsignale zur Verfügung. Dabei kann ein Steuerungsmodul nur Anschlüsse einer Art aufweisen, etwa nur Eingangsanschlüsse oder nur Ausgangsanschlüsse bzw. nur digitale oder nur analoge Anschlüsse. Werden für den Betrieb eines Feldgeräts sowohl analoge wie auch digitale Feldsignale benötigt, oder werden für den Betrieb eines Feldgeräts sowohl Ein- als auch Ausgänge benötigt, so werden üblicherweise die entsprechenden Signalleitungen an mehrere unterschiedliche Steuerungsmodule angeschlossen. Die für ein Feldgerät oder für eine Gruppe von Feldgeräten benötigten Signalleitungen von unterschiedlichen Steuerungsmodulen können zu Signalleitungssträngen zusammengefasst werden. Die einzelnen Signalleitungsstränge werden dann zu den verschiedenen Feldgeräten verlegt. Das Zusammenfassen der einzelnen Signalleitungen zu feldgerätespezifischen Signalleitungssträngen wird auch als Signalrangierung bezeichnet.

Zur Halterung der Steuerungsmodule werden unter anderem Koppeleinheiten eingesetzt, die eine Mehrzahl von Steuerungsmodulen auf einem mechanischen Träger aufnehmen. Die Steuerungsmodule sind in der Regel als Hutschienenklemmen ausgeführt und nebeneinander auf einer als Hutschiene ausgebildeten Koppeleinheit montiert. Hutschienen werden beispielsweise in der Norm DIN EN 6071 beschrieben. Die Datenverbindung zwischen den als Hutschienenklemmen ausgeführten Steuerungsmodulen erfolgt in der Regel über seitlich an den Steuerungsmodulen angebrachte Kontakteinrichtungen. Werden die Steuerungsmodule auf der Hutschiene aneinandergeschoben, so wird über die Kontakteinrichtungen benachbarter Module ein elektrischer Kontakt zur Datenkommunikation hergestellt. In analoger Weise kann auch eine Spannungsversorgung der Steuerungsmodule über seitlich an den Steuerungsmodulen angebrachte Kontakteinrichtungen erfolgen.

Die Feldsignale für die Feldgeräte werden bei als Hutschienenklemmen ausgebildeten Steuerungsmodulen im Allgemeinen an Anschlüssen ausgegeben oder eingelesen, die auf einer der Hutschiene abgewandten Vorderseite der Steuerungsmodule angeordnet sind. Die Anschlüsse sind in der Regel als Anschlussklemmen ausgeführt. Um im Zuge einer Signalrangierung alle Feldsignale, die für ein Feldgerät oder eine Gruppe von Feldgeräten bestimmt sind, zusammenzufassen, können an die Anschlüsse angeschlossene Signalleitungen auf feldgerätespezifische Anschlusselemente querverdrahtet werden. Die feldgerätespezifischen Anschlusselemente bündeln dabei alle für ein Feldgerät oder eine Gruppe von Feldgeräten bestimmten Signalleitungen und sind in der Regel ebenfalls als Klemmanschlüsse ausgebildet.

Derartige Hutschienenklemmen sind beispielsweise aus der DE 44 02 002 B4 vorbekannt.

Die Druckschrift DE 20 2010 006 065 U1 zeigt ein Automatisierungs- oder Steuerungssystem mit nebeneinander angeordneten Busklemmen, welche jeweils eine aufsteckbare Baugruppe aufnehmen. Feldseitige Hardwarekomponenten werden an Kontaktmittel der Busklemmen als stehende Verdrahtung angeschlossen, wobei die Kontaktmittel als Federzug- oder Schraubklemmen ausgebildet sind.

Die Druckschriften DE 10 2006 031 129 A1, DE 10 2007 050 943 A1, DE 37 40 290 C2 und US 2004/0206613 A1 zeigen jeweils Gerätemodule für ein industrielles Steuerungssystem, welche zur Übertragung von Kommunikationsdaten über einen Rückwandbus miteinander verbunden sind.

Die Druckschrift EP 2 227 072 A2 beschreibt eine Leiterkarte nach dem VME-Standard, welche eine Schnittstelle zum Anschluss eines anwendungsspezifischen Verbindungselements aufweist.

Die Druckschrift US 2013/0173868 A1 beschreibt ein Adressierverfahren für die Datenkommunikation zwischen Netzwerkteilnehmern nach dem EtherCAT-Protokoll.

Aufgabe der Erfindung ist es, eine Koppeleinheit für ein industrielles Steuerungssystem anzugeben, an welche industrielle Feldgeräte auf einfache und wenig fehleranfällige Weise angeschlossen werden können. Eine weitere Aufgabe der Erfindung ist es, ein industrielles Steuerungssystem mit einer derartigen Koppeleinheit anzugeben.

Diese Aufgaben werden durch eine Koppeleinheit gemäß Anspruch 1, sowie ein industrielles Steuerungssystem gemäß Anspruch 12 gelöst. In den abhängigen Ansprüchen sind verschiedene Weiterbildungen angegeben.

Eine Koppeleinheit für ein industrielles Steuerungssystem weist wenigstens zwei Modulanschlüsse zur elektrischen Kontaktierung von Steuerungsmodulen, einen Feldanschluss zur elektrischen Kontaktierung eines industriellen Feldgeräts, ein Datenübertragungsmedium und ein Signalübertragungsmedium auf. Jeder der zwei Modulanschlüsse umfasst elektrische Kontaktelemente, die einen Kommunikationssignalbereich und einen Feldsignalbereich ausbilden. Die Kontaktelemente der Kommunikationssignalbereiche der zwei Modulanschlüsse sind über das Datenübertragungsmedium elektrisch leitend miteinander verbunden und die Kontaktelemente der Feldsignalbereiche der zwei Modulanschlüsse sind über das Signalübertragungsmedium mit dem Feldanschluss verbunden.

Über die Kontaktelemente des Kommunikationssignalbereichs und das Datenübertragungsmedium können die Steuerungsmodule beispielsweise Kommunikationsdaten untereinander oder mit einem Steuerungsrechner austauschen. Über die Kontaktelemente des Feldsignalbereichs und das Signalübertragungsmedium können die Steuerungsmodule beispielsweise Feldsignale mit einem an den Feldanschluss angeschlossenen industriellen Steuerungsgerät austauschen. Indem die Modulanschlüsse für die Übertragung sowohl von Kommunikationsdaten, als auch von Feldsignalen genutzt werden, kann auf zusätzliche Anschlüsse für die Übertragung der Feldsignale, beispielsweise in Form von vorderseitigen Klemmanschlüssen an den Steuerungsmodulen, verzichtet werden. Dadurch ist ein vorteilhaft einfaches Austauschen der Steuerungsmodule möglich, ohne die feldseitige Signalverdrahtung lösen zu müssen.

Indem die Feldsignalbereiche beider Modulanschlüsse über das Signalübertragungsmedium der Koppeleinheit mit dem Feldanschluss verbunden sind, können auf dem Feldanschluss vorteilhafterweise Feldsignale beider Steuerungsmodule zusammengefasst werden. Dies erlaubt es, auf vorteilhaft einfache Weise ein Feldgerät bzw. eine Gruppe von Feldgeräten über ein einzelnes Feldsignalübertragungsmedium an die Koppeleinheit anzuschließen. Das Feldsignalübertragungsmedium kann beispielsweise aus einem mehradrigen Kabel oder einem Kabelstrang bestehen. Eine Signalrangierung erfolgt dann direkt in der Koppeleinheit und es muss vorteilhafterweise keine aufwändige und fehleranfällige Querverdrahtung der an die Modulanschlüsse angeschlossenen Steuerungsmodule vorgenommen werden.

Die Koppeleinheit weist eine Busplatine auf, an der die Modulanschlüsse und der Feldanschluss angeordnet sind und welche das Datenübertragungsmedium und das Signalübertragungsmedium umfasst. Dadurch kann das Signalübertragungsmedium in vorteilhaft einfacher Weise mittels auf oder in der Busplatine angeordneten Leiterbahnen ausgebildet werden. Hierdurch ist auf einfache und kostengünstige Weise eine Signalrangierung direkt auf der Koppeleinheit möglich.

Die Koppeleinheit weist einen weiteren Feldanschluss zur elektrischen Kontaktierung eines weiteren industriellen Feldgeräts auf, wobei Kontaktelemente des Feldsignalbereichs wenigstens eines der zwei Modulanschlüsse über das Signalübertragungsmedium mit dem weiteren Feldanschluss elektrisch leitend verbunden sind. Hierdurch ist es auf vorteilhaft einfache Weise möglich, ein weiteres industrielles Feldgerät über den weiteren Feldanschluss an die Koppeleinheit anzuschließen. Indem ein Modulanschluss mit beiden Feldanschlüssen verbunden ist, können vorteilhafterweise Feldgeräte an beiden Feldanschlüssen mit einem an den Modulanschluss angeschlossenen Steuerungsmodul kommunizieren.

Bei einer Weiterbildung der Erfindung bestehen der Kommunikationssignalbereich und der Feldsignalbereich der zwei Modulanschlüsse jeweils aus benachbart angeordneten Kontaktelementen. Dadurch lässt sich auf vorteilhaft einfache Weise ein Modulanschluss realisieren, über den sowohl Kommunikationsdaten, als auch Feldsignale übertragen werden. Vorteilhafterweise lassen sich durch eine benachbarte Anordnung der Kontaktelemente der einzelnen Signalbereiche die Signalbereiche elektrisch voneinander entkoppeln. Hierdurch kann ein Übersprechen von Kommunikationssignalen auf den Feldsignalbereich und das Signalübertragungsmedium oder ein Übersprechen von Feldsignalen auf das Datenübertragungsmedium verhindert werden.

Bei einer Weiterbildung der Erfindung umfasst der Kommunikationssignalbereich der zwei Modulanschlüsse jeweils ein Empfangskontaktelement und ein Sendekontaktelement. Das Sendekontaktelement eines ersten Modulanschlusses ist über das Datenübertragungsmedium mit dem Empfangskontaktelement eines zweiten Modulanschlusses elektrisch leitend verbunden und das Sendekontaktelement des zweiten Modulanschlusses ist über das Datenübertragungsmedium mit dem Empfangskontaktelement des ersten Modulanschlusses elektrisch leitend verbunden. Hierdurch lässt sich auf vorteilhaft einfache Weise eine direkte elektrische Punkt-zu-Punkt-Verbindung zwischen den Kommunikationssignalbereichen der Modulanschlüsse realisieren, wie sie beispielsweise für die Ausbildung eines Datennetzwerks in Linientopologie benötigt wird.

Bei einer Weiterbildung der Erfindung umfasst das Datenübertragungsmedium einen ersten Datenkanal und einen zweiten Datenkanal. Eine erste Anzahl von Kontaktelementen des Kommunikationssignalbereichs der zwei Modulanschlüsse ist mit dem ersten Datenkanal elektrisch leitend verbunden und eine zweite Anzahl von Kontaktelementen des Kommunikationssignalbereichs der zwei Modulanschlüsse ist mit dem zweiten Datenkanal elektrisch leitend verbunden. Hierdurch lässt sich ein Datenübertragungsmedium realisieren, welches vorteilhafterweise eine beidseitige Übertragung von Kommunikationsdaten zwischen den Modulanschlüssen ermöglicht.

Bei einer Weiterbildung der Erfindung ist das Datenübertragungsmedium im Kommunikationssignalbereich jedes Modulanschlusses unterbrochen. Dies ermöglicht es vorteilhafterweise, mittels des Datenübertragungsmediums der Koppeleinheit ein Feldbussystem in Linientopologie zu realisieren, bei dem die übertragenen Kommunikationsdaten die an die Modulanschlüsse angeschlossenen Steuerungsmodule nacheinander durchlaufen.

Bei einer Weiterbildung der Erfindung weist wenigstens einer der zwei Modulanschlüsse elektrische Kontaktelemente auf, die einen Spannungsversorgungsbereich ausbilden und mit einer Feldspannungsversorgung der Koppeleinheit leitend verbunden sind. Dadurch ist eine vorteilhaft einfache Spannungsversorgung aller an den Modulanschlüssen angeschlossenen Steuerungsmodule über eine zentrale, auf der Koppeleinheit verlaufende Feldspannungsversorgung möglich.

Bei einer Weiterbildung der Erfindung sind die Kontaktelemente des Feldsignalbereichs zwischen den Kontaktelementen des Kommunikationssignalbereichs und den Kontaktelementen des Spannungsversorgungsbereichs angeordnet. Hierdurch können die Kontaktelemente der einzelnen Bereiche des Modulanschlusses benachbart voneinander angeordnet werden und es wird vorteilhafterweise ein Übersprechen von Signalen von einem der Bereiche auf Kontaktelemente der anderen Bereiche verhindert.

Bei einer Weiterbildung der Erfindung weist die Koppeleinheit weitere Modulanschlüsse auf. Die Modulanschlüsse weisen eine im Wesentlichen rechteckige Form mit einer langen Seite und einer kurzen Seite auf, wobei die langen Seiten der Modulanschlüsse im Wesentlichen parallel zueinander angeordnet sind. Eine erste Anzahl von Modulanschlüssen ist in einer ersten Reihe voneinander beabstandet angeordnet, wobei die Kontaktelemente der Kommunikationssignalbereiche der ersten Anzahl von Modulanschlüssen der ersten Reihe nach miteinander über das Datenübertragungsmedium elektrisch leitend verbunden sind. Eine zweite Anzahl von Modulanschlüssen ist in einer zweiten Reihe voneinander beabstandet angeordnet, wobei die Kontaktelemente der Kommunikationssignalbereiche der zweiten Anzahl von Modulanschlüssen der zweiten Reihe nach miteinander über das Datenübertragungsmedium elektrisch leitend verbunden sind. Die zweite Reihe ist unter der ersten Reihe und parallel zu der ersten Reihe angeordnet, wobei die Kontaktelemente des Kommunikationssignalbereichs eines letzten kontaktierten Modulanschlusses der ersten Reihe über das Datenübertragungsmedium mit den Kontaktelementen des Kommunikationssignalbereichs eines ersten kontaktierten Modulanschlusses der zweiten Reihe elektrisch leitend verbunden sind.

Hierdurch ist eine vorteilhaft einfache Signalführung über das Datenübertragungsmedium möglich, bei der die Kommunikationsdaten beispielsweise zunächst die Steuerungsmodule durchlaufen, die an die Modulanschlüsse der ersten Reihe angeschlossen sind, und anschließend die Steuerungsmodule durchlaufen, die an die Modulanschlüsse der zweiten Reihe angeschlossen sind. Durch eine zweireihige und benachbarte Anordnung der Modulanschlüsse kann die Koppeleinheit in einer vorteilhaft kompakten Bauform ausgeführt werden.

Bei einer Weiterbildung der Erfindung ist eine dritte Anzahl von Modulanschlüssen in einer dritten Reihe voneinander beabstandet angeordnet, wobei die dritte Reihe an die erste Reihe anschließend angeordnet ist. Die Kontaktelemente der Kommunikationssignalbereiche der dritten Anzahl der Modulanschlüsse sind der dritten Reihe nach miteinander über das Datenübertragungsmedium elektrisch leitend verbunden und die Kontaktelemente des Kommunikationssignalbereichs eines letzten kontaktierten Modulanschlusses der zweiten Reihe sind über das Datenübertragungsmedium mit den Kontaktelementen des Kommunikationssignalbereichs eines ersten kontaktierten Modulanschlusses der dritten Reihe elektrisch leitend verbunden.

Hierdurch können die Modulanschlüsse vorteilhafterweise über das Datenübertragungsmedium blockweise miteinander verbunden werden. Über das Datenübertragungsmedium übertragene Kommunikationsdaten durchlaufen dabei zunächst die an die Modulanschlüsse der ersten und der zweiten Reihe angeschlossenen Steuerungsmodule, ehe sie an die Steuerungsmodule weitergeleitet werden, die an die dritte Reihe von Modulanschlüssen angeschlossen sind. Beispielsweise kann unter der dritten Reihe von Modulanschlüssen eine weitere Reihe von Modulanschlüssen angeordnet werden und im Anschluss an die dritte Reihe über das Datenübertragungsmedium kontaktiert werden. Die erste und die zweite Reihe können dann einen ersten Block von Modulanschlüssen ausbilden, der neben einem zweiten Block angeordnet ist, der aus der dritten und der vierten Reihe von Modulanschlüssen besteht.

Bei einer Weiterbildung der Erfindung umfasst die Koppeleinheit eine Modulanschlussplatine mit den Modulanschlüssen und eine Feldanschlussplatine mit dem Feldanschluss und die Modulanschlussplatine und die Feldanschlussplatine sind über ein Verbindungselement elektrisch leitend verbunden. Auf der Feldanschlussplatine mit dem Feldanschluss kann beispielsweise eine feldgerätespezifische Signalrangierung der über die Modulanschlüsse ausgegebenen Feldsignale erfolgen. Dann muss bei einer Änderung der Signalführung und der verwendeten Konfiguration der Steuerungsmodule vorteilhafterweise nur die Feldanschlussplatine ausgetauscht werden. Das Verbindungselement kann beispielsweise als Steckverbindung ausgebildet sein, was einen vorteilhaft einfachen Austausch der Feldanschlussplatine ermöglicht.

Bei einer Weiterbildung der Erfindung sind die Modulanschlussplatine und die Feldanschlussplatine über ein weiteres Verbindungselement elektrisch leitend miteinander verbunden. Dabei sind die Kontaktelemente der Feldsignalbereiche einer ersten Gruppe von Modulanschlüssen mit dem Verbindungselement elektrisch leitend verbunden und die Kontaktelemente der Feldsignalbereiche einer zweiten Gruppe von Modulanschlüssen sind mit dem weiteren Verbindungselement elektrisch leitend verbunden. Hierdurch kann auf vorteilhaft einfache Weise eine standardisierte Feldsignalübertragung von den Modulanschlüssen der Modulanschlussplatine auf die Feldanschlussplatine realisiert werden. Je eine der Gruppen von Modulanschlüssen und ein mit diesen verbundenes Verbindungselement können einen Anschlussblock bilden und eine Erweiterung der Koppeleinheit um zusätzliche Modulanschlüsse kann durch das Hinzufügen eines weiteren solchen Anschlussblocks erfolgen.

Ein industrielles Steuerungssystem umfasst die Koppeleinheit, die weiterhin einen Umsetzermodulanschluss aufweist, ein Steuerungsmodul und ein Umsetzermodul. Das Steuerungsmodul ist dazu ausgebildet, Kontaktelemente eines der Modulanschlüsse elektrisch leitend zu kontaktieren, um Kommunikationsdaten über Kontaktelemente des Kommunikationssignalbereichs des Modulanschlusses und Feldsignale über Kontaktelemente des Feldsignalbereichs des Modulanschlusses zu übertragen. Das Umsetzermodul ist dazu ausgebildet, Kontaktelemente des Umsetzermodulanschlusses elektrisch leitend zu kontaktieren, und weist eine Schnittstelle zu einem übergeordneten Datenpfad auf. Das Umsetzermodul ist weiterhin dazu ausgebildet, Kommunikationsdaten zwischen der Schnittstelle zu dem übergeordneten Datenpfad und Kontaktelementen eines Kommunikationssignalbereichs des Umsetzermodulanschlusses zu übertragen.

Ein solches Steuerungssystem ermöglicht vorteilhafterweise eine einfache Signalrangierung direkt auf der Koppeleinheit. An dem zweiten Modulanschluss der Koppeleinheit des industriellen Steuerungssystems kann beispielsweise ein weiteres Steuerungsmodul angeschlossen werden. Feldsignale beider Steuerungsmodule können über die Feldsignalbereiche der Modulanschlüsse und das Signalübertragungsmedium auf dem Feldanschluss der Koppeleinheit zusammengefasst werden. Ein industrielles Feldgerät kann dann auf vorteilhaft einfache Weise direkt an den Feldanschluss der Koppeleinheit angeschlossen werden.

Über das Umsetzermodul kann das Datenübertragungsmedium der Koppeleinheit mit dem übergeordneten Datenpfad verbunden werden.

Dies ermöglicht es vorteilhafterweise, für den übergeordneten Datenpfad und das Datenübertragungsmedium unterschiedliche Bitübertragungstechnologien zu verwenden. Beispielsweise kann für den übergeordneten Datenpfad eine Technologie verwendet werden, die sich für eine kabelgebundene Übertragung eignet, während für das Datenübertragungsmedium eine Technologie verwendet werden kann, welche eine besonders schnelle Datenübertragung ermöglicht und beispielsweise auf LVDS basiert.

Bei einer Weiterbildung der Erfindung sind das Umsetzermodul das Steuerungsmodul und das Datenübertragungsmedium dazu ausgebildet, die Kommunikationsdaten mittels E-Bus-Datentelegrammen zu übermitteln. Hierdurch kann eine vorteilhaft schnelle Übertragung von Kommunikationsdaten über das Datenübertragungsmedium realisiert werden.

Bei einer Weiterbildung der Erfindung ist das Umsetzermodul dazu ausgebildet, die Kommunikationsdaten mittels Ethernet-Datentelegrammen, insbesondere mittels EtherCAT-Datentelegrammen, über den übergeordneten Datenpfad zu übertragen. Hierdurch kann das industrielle Steuerungssystem vorteilhafterweise einfach und kostengünstig in ein übergeordnetes Feldbussystem eingegliedert werden.

Bei einer Weiterbildung der Erfindung ist ein Teil des übergeordneten Datenpfads auf der Koppeleinheit angeordnet, wobei der übergeordnete Datenpfad Kontaktelemente des Umsetzermodulanschlusses elektrisch leitend kontaktiert. Somit kann das Umsetzermodul vorteilhafterweise vollständig über den Umsetzermodulanschluss kontaktiert werden und es kann auf ein zusätzliches Verbindungselement zu dem übergeordneten Datenpfad, beispielsweise auf eine Netzwerkbuchse, verzichtet werden.

Bei einer Weiterbildung der Erfindung umfasst das industrielle Steuerungssystem einen Steuerungsrechner und ein Platzhaltermodul, das dazu ausgebildet ist, Kontaktelemente eines der Modulanschlüsse elektrisch leitend zu kontaktieren, um Kommunikationsdaten über die Kontaktelemente des Kommunikationssignalbereichs des Modulanschlusses mit dem Umsetzermodul auszutauschen.

Der Steuerungsrechner ist dazu ausgebildet, über den übergeordneten Datenpfad, das Umsetzermodul und das Datenübertragungsmedium Kommunikationsdaten mit dem Steuerungsmodul und dem Platzhaltermodul auszutauschen, um eine Anzahl der Modulanschlüsse der Koppeleinheit abzufragen. Der Steuerungsrechner ist weiterhin dazu ausgebildet, die Anzahl der Modulanschlüsse aus nach der Abfrage von dem Steuerungsmodul und dem Platzhaltermodul empfangenen Kommunikationsdaten zu ermitteln.

Das Platzhaltermodul kann beispielsweise ausschließlich Kontaktelemente des Kommunikationssignalbereichs des Modulanschluss kontaktieren und keine Einrichtungen zur Erzeugung und Übertragung von Feldsignalen aufweisen. Dadurch kann das Platzhaltermodul vorteilhaft einfach und kostengünstig hergestellt werden. Das Platzhaltermodul kann beispielsweise einen Modulanschluss kontaktieren, der bei einer Konfiguration des industriellen Steuerungssystems nicht mit einem Steuerungsmodul belegt werden soll. Wird über das Datenübertragungsmedium ein Feldbussystem in Linientopologie realisiert, so kann das Platzhaltermodul Kommunikationssignale, welche von dem Steuerungsrechner empfangene Kommunikationsdaten repräsentieren, an ein nachfolgend an das Feldbussystem angeschlossenes Steuerungsmodul weiterleiten.

Außerdem kann das Platzhaltermodul die Kommunikationssignale vorteilhafterweise vor dem Weiterleiten verstärken, um einem Verlust von Kommunikationsdaten durch eine Dämpfung der Kommunikationssignale auf dem Datenübertragungsmedium zu vermeiden. Der Steuerungsrechner kann bei einer Systemabfrage aus den empfangenen Kommunikationsdaten ermitteln, dass einer der Modulanschlüsse von einem Platzhaltermodul belegt wird, welches in einer anderen Konfiguration beispielsweise durch ein Steuerungsmodul ersetzt werden könnte. Insofern kann die durch den Steuerungsrechner abgefragte Anzahl der Modulanschlüsse beispielsweise durch die Zahl an Modulanschlüssen gegeben sein, die durch Platzhaltermodule belegt sind.

Ein weiterer Vorteil des erfindungsgemäßen Steuerungssystems kann darin gesehen werden, dass Maschinenherstellern für eine große Anzahl an gleich oder sehr ähnlich ausgebildeten Serienmaschinen entsprechende Koppeleinheiten bereitgestellt werden können, die in immer gleicher Weise mit identischen Steuerungsmodulen schnell, einfach und fehlerresistent bestückt werden. Die Koppeleinheit fungiert quasi als eine Art Rangierebene (Distribution Board) und ersetzt somit das manuelle Rangieren mit Einzeladern. Dieses erzeugt bei der Produktion der Serienmaschinen weniger Fehler und einen schnelleren Aufbau des Steuerungssystems. Gleichteile, die über verschiedene Serienmaschinen häufige Wiederverwendung finden, können als steckbare Module ausgelegt werden. Bei geringfügigen Abweichungen zur Serie und/oder erweitertem Funktionsumfang des Steuerungssystems können in einfacher Weise andere, den gewünschten Funktionsumfang bereitstellende Module anstelle der in der Serie verwendeten Module mit der Koppeleinheit verbunden werden. Alternativ oder zusätzlich können durch Platzhaltermodule Steckplätze für größere Ausbauten einer Maschinensteuerung reserviert werden. Es besteht aber natürlich weiterhin die zusätzliche Möglichkeit der Kombination mit einem aus dem Stand der Technik bekannten Steuerungssystem, um modulare Erweiterungen der Maschine zu ermöglichen und somit applikationsspezifische Elemente des Steuerungssystems zu implementieren. Verschiedene Signalformen unterschiedlicher Steuerungsmodule können applikationsspezifisch auf einem externen Anschluss bzw. Feldanschluss pro Koppeleinheit zusammengefasst werden und ermöglichen somit eine Verbindung einer Koppeleinheit mit einem einzigen vorkonfektionierten Kabelbaum.

Die Erfindung wird im Folgenden anhand von Figuren näher erläutert. Dabei zeigen in jeweils schematischer Darstellung:
Fig. 1 eine Darstellung eines industriellen Steuerungssystems gemäß einer ersten Ausführungsform der Erfindung;
Fig. 2 eine Darstellung einer ersten Busplatine einer ersten Koppeleinheit des industriellen Steuerungssystems gemäß der ersten Ausführungsform;
Fig. 3 eine Darstellung von Kommunikationssignalbereichen zweier Modulanschlüsse der ersten Busplatine;
Fig. 4 eine Aufsicht auf einen ersten Modulanschluss der ersten Busplatine des industriellen Steuerungssystems nach der ersten Ausführungsform;
Fig. 5 eine Darstellung eines industriellen Steuerungssystems gemäß einer zweiten Ausführungsform der Erfindung;
Fig. 6 eine Darstellung eines industriellen Steuerungssystems gemäß einer dritten Ausführungsform der Erfindung;
Fig. 7 eine Aufsicht auf eine vierte Busplatine einer vierten Koppeleinheit eines industriellen Steuerungssystems gemäß einer vierten Ausführungsform der Erfindung;
Fig. 8 einen Ausschnitt einer fünften Busplatine einer fünften Koppeleinheit eines industriellen Steuerungssystems einer fünften Ausführungsform der Erfindung;
Fig. 9 eine Darstellung einer sechsten Busplatine einer sechsten Koppeleinheit eines industriellen Steuerungssystems gemäß einer sechsten Ausführungsform der Erfindung;
Fig. 10 eine Darstellung von Kommunikationssignalbereichen vierer Modulanschlüsse der sechsten Busplatine;
Fig. 11 eine Darstellung eines industriellen Steuerungssystems gemäß einer siebten Ausführungsform der Erfindung; und
Fig. 12 eine Ansicht einer achten Koppeleinheit eines industriellen Steuerungssystems gemäß einer achten Ausführungsform der Erfindung.

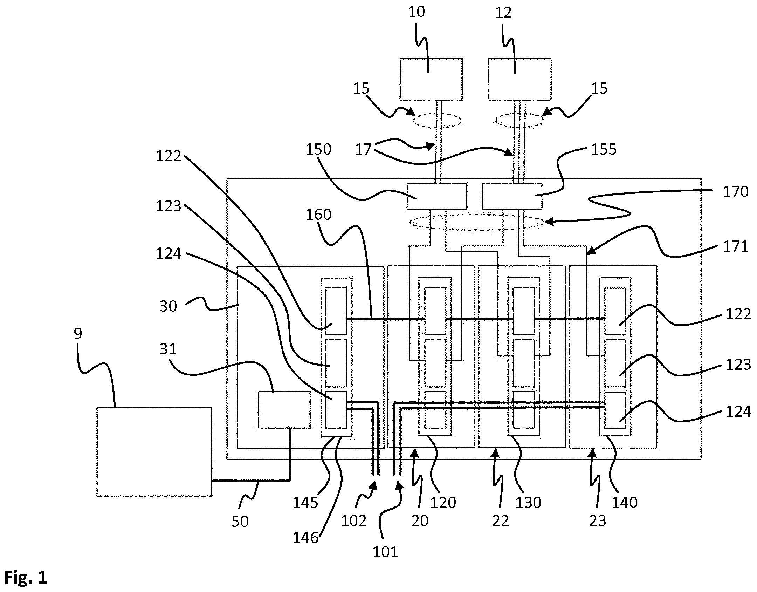

**Figur 1** zeigt eine schematische Darstellung eines ersten industriellen Steuerungssystems 1 mit einer ersten Koppeleinheit 100. Die erste Koppeleinheit 100 umfasst eine erste Busplatine 91 und eine Mehrzahl von Modulanschlüssen. Beispielhaft sind in Figur 1 ein erster Modulanschluss 120, ein zweiter Modulanschluss 130, ein dritter Modulanschluss 140 und ein vierter Modulanschluss 145 dargestellt. Des Weiteren umfasst die erste Koppeleinheit 100 eine Mehrzahl von Feldanschlüssen, wobei ein Feldanschluss 150 und ein weiterer Feldanschluss 155 dargestellt sind. Die Modulanschlüsse 120, 130, 140, 145 und die Feldanschlüsse 150, 155 sind an der Busplatine 91 angeordnet und können beispielsweise jeweils als Elemente einer elektrischen Steckverbindung, etwa als Stecker oder Buchse, ausgebildet sein.

Die erste Busplatine 91 kann beispielsweise als eine Leiterkarte oder Leiterplatte ausgebildet sein und eine gedruckte Schaltung umfassen. Die Busplatine 91 weist ein elektrisch isolierendes Material auf, etwa einen glasfaserverstärkten Kunststoff, und ist bevorzugt als starre Leiterplatte ausgeführt. Bevorzugt umfasst die Busplatine 91 vier oder mehr Leiterbahnlagen, von denen zwei jeweils an einer Oberfläche der Busplatine 91 angeordnet sind und zwei im Inneren der Busplatine 91 angeordnet und beispielsweise einlaminiert sind.

Der erste Modulanschluss 120, der zweite Modulanschluss 130, der dritte Modulanschluss 140 und der vierte Modulanschluss 145 sind, soweit sich aus der Beschreibung keine Unterschiede ergeben, identisch ausgeführt. Die Modulanschlüsse 120, 130, 140, 145 sind voneinander beabstandet in einer Reihe auf der ersten Busplatine 91 angeordnet. Dabei ist der vierte Modulanschluss 145 an einem Ende der Reihe angeordnet. Der nächste Anschluss der Reihe ist der erste Modulanschluss 120, gefolgt von dem zweiten Modulanschluss 130. Der dritte Modulanschluss 140 ist neben dem zweiten Modulanschluss 130 am anderen Ende der Reihe angeordnet. Die Modulanaschlüsse 120, 130, 140, 145 verfügen jeweils über einen Kommunikationssignalbereich 122, einen Feldsignalbereich 123 und einen Spannungsversorgungsbereich 124.

Die Feldanschlüsse 150, 155 sind, soweit sich aus der Beschreibung keine Unterschiede ergeben, identisch ausgeführt. Die Feldanschlüsse 150, 155 und die Modulanschlüsse 120, 130, 140, 145 können sich auf derselben Seite der ersten Busplatine 91 befinden, sie können aber auch auf unterschiedlichen Seiten der ersten Busplatine 91 angeordnet sein.

Die erste Koppeleinheit 100 weist außerdem ein Datenübertragungsmedium 160 auf, welches die Modulanschlüsse 120, 130, 140, 145 der Reihe nach elektrisch leitend miteinander verbindet. Dabei stellt das Datenübertragungsmedium 160 jeweils eine elektrisch leitende Verbindung zwischen zwei benachbarten Modulanschlüssen 120, 130, 140, 145 her und kontaktiert die Modulanschlüsse 120, 130 140, 145 jeweils in dem Kommunikationssignalbereich 122. Das Datenübertragungsmedium 160 verbindet den vierten Modulanschluss 145 mit dem ersten Modulanschluss 120 und den ersten Modulanschluss 120 zusätzlich mit dem zweiten Modulanschluss 130. Der zweite Modulanschluss 130 ist neben dem ersten Modulanschluss 120 über das Datenübertragungsmedium 160 auch mit dem dritten Modulanschluss 140 elektrisch leitend verbunden.

Die erste Koppeleinheit 100 umfasst weiterhin ein Signalübertragungsmedium 170, welches seinerseits eine Mehrzahl von Signalleitungen 171 umfasst. Der erste Modulanschluss 120 ist über eine der Signalleitungen 171 des Signalübertragungsmediums 170 mit dem Feldanschluss 150 und über eine weitere der Signalleitungen 171 mit dem weiteren Feldanschluss 155 elektrisch leitend verbunden. Der zweite Modulanschluss 130 ist über jeweils eine der Signalleitungen 171 sowohl mit dem Feldanschluss 150, als auch mit dem weiteren Feldanschluss 155 elektrisch leitend verbunden. Der dritte Modulanschluss 140 ist über eine der Signalleitungen 171 mit dem weiteren Feldanschluss 155 elektrisch leitend verbunden. Die Signalleitungen 171 kontaktieren die Modulanschlüsse 120, 130, 140 jeweils in dem Feldsignalbereich 123. Der als Umsetzermodulanschluss 146 verwendete vierte Modulanschluss 145 ist nicht an das Signalübertragungsmedium 170 angeschlossen.

Die erste Koppeleinheit 100 umfasst darüber hinaus eine Feldspannungsversorgung 101. Die Feldspannungsversorgung 101 umfasst zwei Spannungsleitungen und ist der Reihe nach mit dem ersten Modulanschluss 120, dem zweiten Modulanschluss 130 und dem dritten Modulanschluss 140 elektrisch leitend verbunden. Dabei kontaktieren die Spannungsleitungen der Feldspannungsversorgung die Modulanschlüsse 120, 130, 140 jeweils in dem Spannungsversorgungsbereich 124. Der als Umsetzermodulanschluss 146 verwendete vierte Modulanschluss 145 ist nicht an die Feldspannungsversorgung 101 angeschlossen.

Das Datenübertragungsmedium 160, die Signalleitungen 171 des Signalübertragungsmediums 170 und die Spannungsleitungen der Feldspannungsversorgung 101 sind jeweils als eine oder mehrere Leiterbahnen ausgebildet, die in den Leiterbahnebenen der ersten Busplatine 91 angeordnet sind.

Das erste industrielle Steuerungssystem 1 umfasst neben der ersten Koppeleinheit 100 mehrere Steuerungsmodule, welche die Modulanschlüsse 120, 130, 140 elektrisch leitend kontaktieren. Ein erstes Steuerungsmodul 20 kontaktiert den ersten Modulanschluss 120, ein zweites Steuerungsmodul 22 kontaktiert den zweiten Modulanschluss 130 und ein drittes Steuerungsmodul 23 kontaktiert den dritten Modulanschluss 140. Hierzu umfassen die Steuerungsmodule 20, 22, 23 jeweils ein zu den Modulanschlüssen 120, 130, 140 passendes Anschlusselement, welches jeweils an den der ersten Busplatine 91 der ersten Koppeleinheit 100 zugewandten Seiten der Steuerungsmodule 20, 22, 23 angeordnet ist. Über die Modulanschlüsse 120, 130, 140 besteht ein elektrischer Kontakt zwischen den Steuerungsmodulen 20, 22, 23 und dem Datenübertragungsmedium 160, dem Signalübertragungsmedium 170 und der Feldspannungsversorgung 101.

Weiterhin umfasst das erste industrielle Steuerungssystem 1 ein erstes Umsetzermodul 30, welches den als Umsetzermodulanschluss 146 verwendeten vierten Modulanschluss 145 elektrisch leitend kontaktiert. Hierzu verfügt das erste Umsetzermodul 30 über ein Anschlusselement, welches ausgebildet ist wie die Anschlusselemente der Steuerungsmodule 20, 22, 23. Das erste Umsetzermodul 30 kontaktiert über den vierten Modulanschluss 145 das Datenübertragungsmedium 160 der ersten Busplatine 91.

Sind die Modulanschlüsse 120, 130, 140, 145 als Elemente einer Steckverbindung ausgebildet, so können die Anschlusselemente der Steuerungsmodule 20, 22, 23 und des ersten Umsetzermoduls 30 als zu den Modulanschlüssen 120, 130, 140, 145 passende Stecker oder Buchsen ausgebildet sein.

Das erste Umsetzermodul 30 weist eine Schnittstelle 31 zu einem übergeordneten Datenpfad 50 auf und ist über die Schnittstelle 31 an den übergeordneten Datenpfad 50 angeschlossen. Die Schnittstelle 31 ist an dem ersten Umsetzermodul 30 angeordnet und kann sich beispielsweise an einer Seitenfläche des ersten Umsetzermoduls 30 befinden, die einer Seitenfläche mit dem Anschlusselement gegenüberliegt. Der übergeordnete Datenpfad 50 stellt eine elektrisch leitende Verbindung zu einem Steuerungsrechner 9 des ersten industriellen Steuerungssystems 1 her. Der übergeordnete Datenpfad 50 kann beispielsweise Teil eines Feldbussystems sein und beispielsweise als EtherCAT-Feldbus ausgebildet sein.

Bei einem EtherCAT-Feldbus kann der übergeordnete Datenpfad 50 eine oder mehrere Ethernet-Verbindungen umfassen, welche beispielsweise kabelgebunden ausgeführt sein können. Die Schnittstelle 31 des ersten Umsetzermoduls 30 kann in solch einem Fall einen oder mehrere Netzwerkanschlüsse umfassen, beispielsweise in Form von Netzwerkbuchsen. Die Netzwerkbuchsen können beispielsweise als RJ-45 Buchsen ausgestaltet sein.

An den Feldanschluss 150 und den weiteren Feldanschluss 155 sind über je ein Feldsignalübertragungsmedium 15 ein industrielles Feldgerät 10 bzw. ein weiteres industrielles Feldgerät 12 zur elektrischen Kontaktierung angeschlossen. Die Feldsignalübertragungsmedien 15 umfassen jeweils eine oder mehrere Feldsignalleitungen 17. Ein erstes der Feldsignalübertragungsmedien 15 verbindet den Feldanschluss 150 mit dem industriellen Feldgerät 10. Ein zweites der Feldsignalübertragungsmedien 15 verbindet den weiteren Feldanschluss 155 mit dem weiteren industriellen Feldgerät 12. Die industriellen Feldgeräte 10, 12 können beispielsweise Antriebe oder Messumformer mit Sensoren sein und können zur Prozessausführung und -überwachung verwendet werden.

Das Feldsignalübertragungsmedium 15, welches den Feldanschluss 150 mit dem industriellen Feldgerät 10 verbindet, bündelt alle Feldsignalleitungen 17, welche für die Kommunikation zwischen dem industriellen Feldgerät 10 und der Steuerebene des industriellen Steuerungssystems 1 benötigt werden, und bildet einen Feldsignalleitungsstrang. Dadurch kann das industrielle Feldgerät 10 über das Feldsignalübertragungsmedium 15, welches beispielsweise als ein Kabel oder ein Kabelstrang ausgebildet sein kann, angesteuert werden. Analog bündelt das Feldsignalübertragungsmedium 15 zwischen dem weiteren Feldanschluss 155 und dem weiteren industriellen Feldgerät 12 alle Feldsignalleitungen 17 für die Ansteuerung des Weiteren industriellen Feldgeräts 12.

Sind die Feldsignalübertragungsmedien 15 als Kabelstränge ausgeführt, können die Feldsignalleitungen 17 beispielsweise als mehradrige Kabel ausgebildet sein. Handelt es sich bei den Feldsignalübertragungsmedien 15 um jeweils ein einzelnes Kabel, so kann dieses Kabel mehrere Adern aufweisen, wobei die Feldsignalleitungen 17 jeweils eine oder mehrere der Adern des Kabels umfassen. Die Feldsignalleitungen 17 und/oder die Feldsignalübertragungsmedien 15 können eine Kabelschirmung und/oder verdrillte Adernpaare zur besseren Abschirmung der Feldsignalleitungen 17 gegen elektromagnetische Störeinflüsse aufweisen.

Die Steuerungsmodule 20, 22, 23 und das erste Umsetzermodul 30 können dazu ausgebildet sein, über eine kraftschlüssige und/oder formschlüssige Verbindung mit den Modulanschlüssen 120, 130, 140, 145 und/oder der ersten Busplatine 91 verbunden zu sein. Dadurch kann eine stabile mechanische Verbindung zwischen den Modulen 20, 22, 23, 30 und der ersten Busplatine 91 hergestellt werden. Die Steuerungsmodule 20, 22, 23 und das erste Umsetzermodul 30 können beispielsweise über Rastnasen verfügen, welche neben den Anschlusselementen zu den Modulanschlüssen 120, 130, 140, 145 angeordnet sind und in zu den Rastnasen passende Aussparungen in der ersten Busplatine 91 verankernd eingreifen.

Das erste Umsetzermodul 30 ist dazu ausgebildet, Kommunikationsdaten über den übergeordneten Datenpfad 50 und die Schnittstelle 31 von dem Steuerungsrechner 9 zu empfangen und die Kommunikationsdaten über den vierten Modulanschluss 145 und das Datenübertragungsmedium 160 an die Steuerungsmodule 20, 22, 23 weiterzuleiten. Des Weiteren ist das erste Umsetzermodul 30 dazu ausgebildet, über das Datenübertragungsmedium 160 Kommunikationsdaten von den Steuerungsmodulen 20, 22, 23 zu empfangen und über den übergeordneten Datenpfad 50 an den Steuerungsrechner 9 zu übertragen.

Das erste Umsetzermodul 30 verfügt für die Kommunikation mit den Steuerungsmodulen 20, 22, 23 über Sende- und Empfangseinrichtungen, welche über den vierten Modulanschluss 145 mit dem Datenübertragungsmedium 160 elektrisch leitend in Kontakt stehen. Analog verfügen das erste Steuerungsmodul 20, das zweite Steuerungsmodul 22 und das dritte Steuerungsmodul 23 jeweils über Sende- und Empfangseinrichtungen, welche über den ersten Modulanschluss 120, den zweiten Modulanschluss 130 bzw. den dritten Modulanschluss 140 mit dem Datenübertragungsmedium 160 elektrisch leitend in Kontakt stehen.

Das Datenübertragungsmedium 160 bildet einen Feldbus in Linientopologie zwischen dem ersten Umsetzermodul 30, dem ersten Steuerungsmodul 20, dem zweiten Steuerungsmodul 22 und dem dritten Steuerungsmodul 23. Die Steuerungsmodule 20, 22, 23 sind jeweils dazu ausgebildet, Kommunikationsdaten über das Datenübertragungsmedium 160 von einem benachbarten Modul zu empfangen, die Kommunikationsdaten zu verarbeiten und über das Datenübertragungsmedium 160 an ein weiteres benachbartes Modul weiterzuleiten.

Entsprechend empfängt das erste Steuerungsmodul 20 Kommunikationsdaten von dem ersten Umsetzermodul 30 und sendet die Kommunikationsdaten nach der Datenverarbeitung über das Datenübertragungsmedium 160 an das zweite Steuerungsmodul 22. Das zweite Steuerungsmodul 22 sendet die Kommunikationsdaten nach der Datenverarbeitung über das Datenübertragungsmedium 160 an das dritte Steuerungsmodul 23 weiter. Nachdem das dritte Steuerungsmodul 23 die Kommunikationsdaten verarbeitet hat, sendet es diese über das Datenübertragungsmedium 160 an das zweite Steuerungsmodul 22 zurück. Von dem zweiten Steuerungsmodul 22 werden die Kommunikationsdaten über das Datenübertragungsmedium 160 und das erste Steuerungsmodul 20 an das erste Umsetzermodul 30 zurückgesendet, welches die Kommunikationsdaten über den übergeordneten Datenpfad 50 an den Steuerungsrechner 9 überträgt.

Bei der Datenverarbeitung der Kommunikationsdaten durch die Steuerungsmodule 20, 22, 23 können Steuerungsdaten und Steuerungsbefehle durch die Steuerungsmodule 20, 22, 23 aus den Kommunikationsdaten ausgelesen und in ausgehende Feldsignale umgesetzt werden. Die ausgehenden Feldsignale können anschließend über die Feldsignalbereiche 123 der Modulanschlüsse 120, 130, 140, das Signalübertragungsmedium 170 und die Feldanschlüsse 150, 155 an die Feldgeräte 10, 12 übertragen werden. Außerdem können bei der Datenverarbeitung durch die Steuerungsmodule 20, 22, 23 eingehende Feldsignale, welche zuvor durch die Steuerungsmodule 20, 22, 23 von den Feldgeräten 10, 12 über die Modulanschlüsse 120, 130, 140 empfangen wurden, als Messdaten in die Kommunikationsdaten eingelesen und an den Steuerungsrechner 9 zurückgesendet werden.

Über die Feldspannungsversorgung 101 werden die Steuerungsmodule 20, 22, 23 mit einer feldseitigen elektrischen Versorgungspannung versorgt. Die Steuerungsmodule 20, 22, 23 sind über die Modulanschlüsse 120, 130, 140 parallel an die Spannungsleitungen der Feldspannungsversorgung 101 angeschlossen. Die feldseitige Versorgungsspannung kann als externe Spannung über auf der ersten Busplatine 91 der ersten Koppeleinheit 100 angeordnete Kontakteinheiten an die Feldspannungsversorgung 101 angelegt werden. Außerdem kann die Koppeleinheit 100 elektronische Bauelemente umfassen, die dazu ausgebildet sind, die feldseitige Versorgungsspannung von der extern angelegten Spannung galvanisch zu trennen. Die feldseitige Versorgungsspannung kann beispielsweise eine Gleichspannung sein und 24 V betragen.

Zur Spannungsversorgung des ersten Umsetzermoduls 30 umfasst die erste Koppeleinheit 100 eine busseitige Spannungsversorgung 102. Die busseitige Spannungsversorgung 102 kann eine oder mehrere Spanungsleitungen umfassen, welche beispielsweise als Leiterbahnen auf der ersten Busplatine 91 ausgebildet sein können. Die busseitige Spannungsversorgung 102 kontaktiert den Spannungsversorgungsbereich 124 des als Umsetzermodulanschluss 146 genutzten vierten Modulanschlusses 145. Wie bei der feldseitigen Versorgungsspannung kann an die busseitige Spannungsversorgung 102 eine externe Spannung über auf der ersten Busplatine 91 ausgebildete Kontakteinheiten angelegt werden. Die Spannungen auf der busseitigen Spannungsversorgung 102 und der Feldspannungsversorgung 101 können galvanisch getrennt sein, um eine Übertragung von elektromagnetischen Störungen zwischen Kommunikationssignalen, welche die Kommunikationsdaten repräsentieren, und den Feldsignalen zu verhindern.

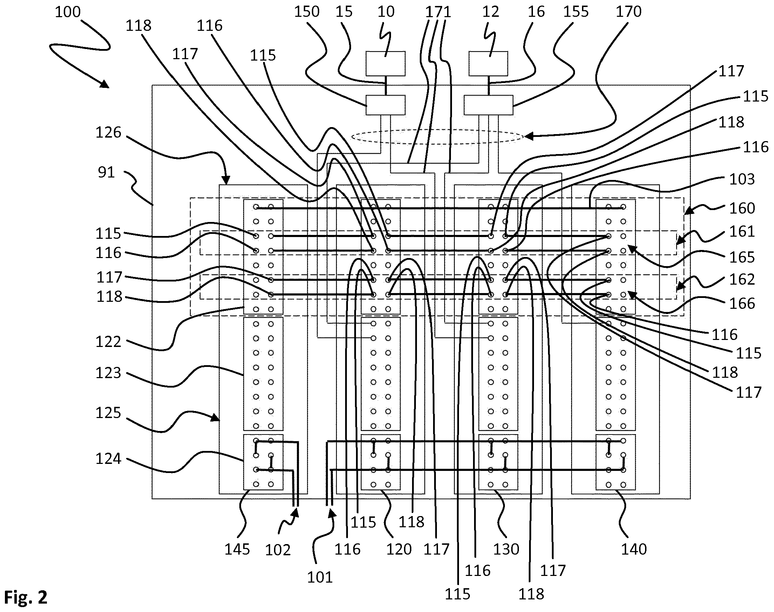

**Figur 2** zeigt einen Ausschnitt der ersten Koppeleinheit 100, in welchem die genauere Ausgestaltung des Datenübertragungsmediums 160, des Signalübertragungsmediums 170 und der Spannungsversorgungen 101, 102 dargestellt ist. Der erste Modulschluss 120, der zweite Modulanschluss 130, der dritte Modulanschluss 140 und der als Umsetzermodulanschluss 146 verwendete vierte Modulanschluss 145 sind im Wesentlichen identisch ausgebildet. Die Modulanschlüsse 120, 130, 140, 145 sind jeweils rechteckig ausgebildet und weisen jeweils zwei lange Seiten 125 und zwei kurze Seiten 126 auf. Die Modulanschlüsse 120, 130, 140, 145 sind entlang der langen Seiten 125 parallel zueinander und voneinander beabstandet auf der ersten Busplatine 91 angeordnet. Die kurzen Seiten 126 der Modulanschlüsse 120, 130, 140, 145 sind fluchtend ausgerichtet.

Die Modulschlüsse 120, 130, 140, 145 verfügen jeweils über vierzig elektrische Kontaktelemente 110. Sechzehn der Kontaktelemente 110 bilden den Kommunikationssignalbereich 122, sechzehn weitere der Kontaktelemente 110 bilden den Feldsignalbereich 123 und acht der Kontaktelemente 110 bilden den Spannungsversorgungsbereich 124 der Modulanschlüsse 120, 130, 140, 145. Die Kontaktelemente 110 des Kommunikationssignalbereichs 122, des Feldsignalbereichs 123 und des Spannungsversorgungsbereichs 124 sind dabei jeweils benachbart zueinander angeordnet. Die Kontaktelemente 110 können beispielsweise als Kontakte einer elektrischen Steckverbindung ausgebildet sein und beispielsweise Kontaktstifte oder Kontakthülsen sein.

Die elektrischen Kontaktelemente 110 sind in zwei zu der langen Seite 125 der Modulanschlüsse 120, 130, 140, 145 parallelen Kontaktreihen mit jeweils zwanzig Kontaktelementen 110 angeordnet. In den beiden Kontaktreihen sind jeweils acht Kontaktelemente 110 des Kommunikationssignalbereichs 122 bzw. des Feldsignalbereichs 123 und vier Kontaktelemente 110 des Spannungsversorgungsbereichs 124 nebeneinander angeordnet. Die Kontaktelemente 110 des Feldsignalbereichs 123 sind zwischen den Kontaktelementen 110 des Kommunikationssignalbereichs 122 und den Kontaktelementen 110 des Spannungsversorgungsbereichs 124 angeordnet.

Die Kontaktelemente 110 der Kommunikationssignalbereiche 122 aller Modulanschlüsse 120, 130, 140, 145 sind im Wesentlichen auf die gleiche Weise mit dem Datenübertragungsmedium 160 verbunden.

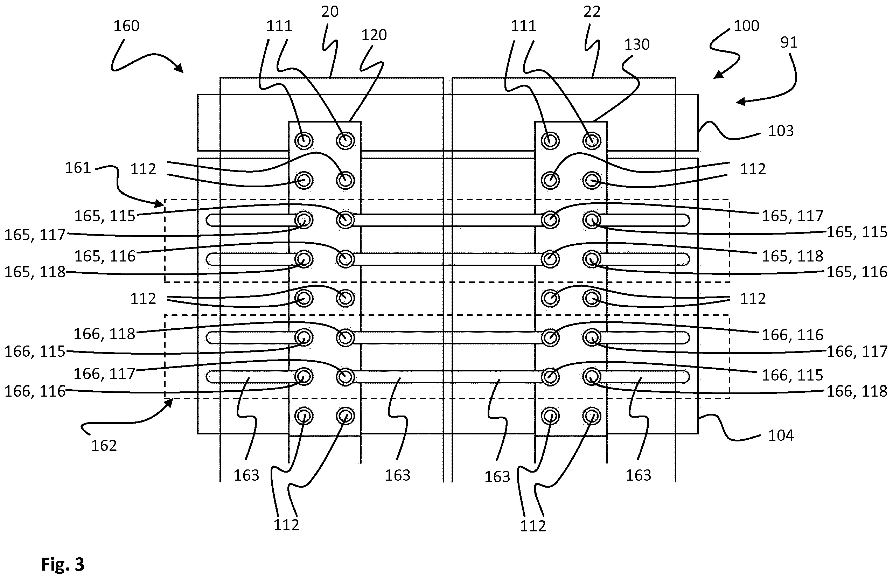

Anhand der in **Figur 3** dargestellten Kommunikationssignalbereiche 122 des ersten Modulanschlusses 120 und des zweiten Modulanschlusses 130 wird die Funktion der Kontaktelemente 110 der Kommunikationssignalbereiche 122 näher erläutert.

Die beiden äußersten Kontaktelemente 110 der Kommunikationssignalbereiche 122, welche jeweils an einer der kurzen Seiten 126 der Modulanschlüsse 120, 130, 140, 145 angeordnet sind, fungieren als Spannungskontaktelemente 111 und sind jeweils parallel zueinander mit einer Busspannungsleitung 103 des Datenübertragungsmediums 160 elektrisch leitend verbunden. Über die Busspannungsleitung 103 und die Spannungskontaktelemente 111 können die Sende- und Empfangseinheiten der Steuerungsmodule 20, 22, 23 und des ersten Umsetzermoduls 30 mit einer elektrischen Busspannung versorgt werden. Das Umsetzermodul 30 kann beispielsweise dazu ausgebildet sein, die Busspannung aus der an die busseitige Spannungsversorgung 102 anliegenden externen Spannung zu erzeugen, etwa mittels eines Spannungswandlers.

Die nächsten beiden Kontaktelemente 110 des Kommunikationssignalbereichs 122, welche neben den Spannungskontaktelementen 111 angeordnet sind, bilden Massekontaktelemente 112 und sind jeweils mit einer Massefläche 104 des Datenübertragungsmediums 160 elektrisch leitend verbunden. Die Massefläche 104 kann beispielsweise als zusammenhängende Leiterfläche der ersten Busplatine 91 ausgebildet sein und auf einer oder beiden Oberflächen der ersten Busplatine 91 angeordnet sein. Die Massefläche 104 kann beispielsweise den Bereich der ersten Busplatine 91, in welchem das Datenübertragungsmedium 160 angeordnet ist, vollständig bedecken und so das Datenübertragungsmedium 160 von äußeren elektromagnetischen Störungen abschirmen.

An die Massekontaktelemente 112 schließt sich eine erste Anzahl 165 von insgesamt vier Kontaktelementen 110 an, wobei jeweils zwei der Kontaktelemente 110 der ersten Anzahl 165 in einer der beiden Kontaktreihen angeordnet sind. Dabei umfasst eine Kontaktreihe ein Sendekontaktelement 115 und ein benachbartes weiteres Sendekontaktelement 116, die andere der Kontaktreihen umfasst ein Empfangskontaktelement 117 und ein benachbartes weiteres Empfangskontaktelement 118.

An die erste Anzahl 165 von Kontaktelementen 110 schließt sich, durch je ein Massekontaktelement 112 pro Kontaktreihe getrennt, eine zweite Anzahl 166 von Kontaktelementen 110 an. Die zweite Anzahl 166 umfasst wiederum insgesamt vier Kontaktelemente 110, wobei in jeder der beiden Kontaktreihen je zwei Kontaktelemente 110 angeordnet sind. In einer der Kontaktreihen folgt auf die Massekontaktelemente 112 jeweils ein Empfangskontaktelement 117 sowie ein weiteres Empfangskontaktelement 118, in der anderen Kontaktreihe ein Sendekontaktelement 115 und ein weiteres Sendekontaktelement 116. Dabei sind die Empfangskontaktelemente 117, 118 der zweiten Anzahl 166 von Kontaktelementen 110 in der Kontaktreihe angeordnet, in der sich die Sendekontaktelemente 115, 116 der ersten Anzahl 165 von Kontaktelementen 110 befinden. Die Sendekontaktelemente 115, 117 der zweiten Anzahl 166 von Kontaktelementen 110 sind in der Kontaktreihe angeordnet, in der sich die Empfangskontaktelemente 117, 118 der ersten Anzahl 165 von Kontaktelementen 110 befinden. An die zweite Anzahl 166 von Kontaktelementen 110 schließt sich im Kommunikationssignalbereich 122 pro Kontaktreihe jeweils zwei Massekontaktelemente 112 an.

Das Datenübertragungsmedium 160 weist einen ersten Datenkanal 161 und einen zweiten Datenkanal 162 auf. Die Datenkanäle 161, 162 umfassen jeweils mehrere Datenleitungen 163. Die Sendekontaktelemente 115, 116 und die Empfangskontaktelemente 117, 118 der ersten Anzahl 165 von Kontaktelementen 110 sind mit den Datenleitungen 163 des ersten Datenkanals 161 elektrisch leitend verbunden. Die Sendekontaktelemente 115, 116 und Empfangskontaktelemente 117, 118 der zweiten Anzahl 166 kontaktieren die Datenleitungen 163 des zweiten Datenkanals 162.

Die Datenleitungen 163 können als Leiterbahnen der ersten Busplatine 91 ausgebildet sein. Sie können beispielsweise in Leiterbahnlagen angeordnet sein, welche sich im Inneren der ersten Busplatine 91 befinden. Die Massefläche 104 des Datenübertragungsmediums 160 kann auf den Oberflächen der ersten Busplatine 91 beispielsweise über und/oder unter den Datenleitungen 163 angeordnet sein.

Die Datenleitungen 163 verbinden immer eines der Sendekontaktelement 115 eines der Modulanschlüsse 120, 130, 140, 145 mit einem der Empfangskontaktelemente 117 des benachbarten Modulanschlusses 120, 130, 140, 145, beziehungsweise eines der weiteren Sendekontaktelemente 116 mit einem der weiteren Empfangskontaktelemente 118 des benachbarten Modulanschlusses 120, 130, 140, 145. Eine der Datenleitungen 163 verbindet also das Sendekontaktelement 115 der ersten Anzahl 165 von Kontaktelementen 110 des ersten Modulanschlusses 120 mit dem Empfangskontaktelement 117 der ersten Anzahl 165 von Kontaktelementen 110 des zweiten Modulanschlusses 130. Eine weitere der Datenleitungen 163 verbindet das weitere Sendekontaktelement 116 der ersten Anzahl 165 von Kontaktelementen 110 des ersten Modulanschlusses 120 mit dem weiteren Empfangskontaktelement 118 der ersten Anzahl 165 von Kontaktelementen 110 des zweiten Modulanschlusses 130. Genauso sind jeweils die Sendekontaktelemente 115, 116 der zweiten Anzahl 166 von Kontaktelementen 110 des zweiten Modulanschlusses 130 mit den Empfangskontaktelementen 117, 118 der zweiten Anzahl 166 von Kontaktelementen 110 des ersten Modulanschlusses 120 über je eine der Datenleitungen 163 verbunden.

Wie in Figur 3 und Figur 2 dargestellt, ist der Kommunikationssignalbereich 122 des dritten Modulanschlusses 140 in analoger Weise über den ersten Datenkanal 161 und den zweiten Datenkanal 162 des Datenübertragungsmediums 160 an den zweiten Modulanschluss 130 angeschlossen. Da der dritte Modulanschluss 140 mit keinem weiteren Modulanschluss verbunden ist, sind die Sendekontaktelemente 115, 116 der ersten Anzahl 165 von Kontaktelementen 110 des dritten Modulanschlusses 140 nicht kontaktiert. Ebenso wenig sind die Empfangskontaktelemente 117, 118 der zweiten Anzahl 166 von Kontaktelementen 110 des dritten Modulanschlusses 140 kontaktiert.

In ähnlicher Weise wie der dritte Modulanschluss 140 mit dem zweiten Modulanschluss 130 verbunden ist, ist der in Figur 2 dargestellte vierte Modulanschluss 145 über den ersten Datenkanal 161 und den zweiten Datenkanal 162 des Datenübertragungsmediums 160 mit dem ersten Modulanschluss 120 verbunden. Wie in Figur 2 dargestellt sind bei dem vierten Modulanschluss 145 die Empfangskontaktelemente 117, 118 der ersten Anzahl 165 von Kontaktelementen 110 und die Sendekontaktelemente 117, 118 der zweiten Anzahl 166 von Kontaktelementen 110 nicht an das Datenübertragungsmedium 160 angeschlossen.

Die Massefläche 104 des Datenübertragungsmediums 160 bildet eine zusammenhängende Massefläche aus, welche sich über alle Modulanschlüsse 120, 130, 140, 145 der Busplatine 91 der ersten Koppeleinheit 100 erstreckt. Die Massefläche 104 kann gleichzeitig sowohl in der obersten, als auch in der untersten Leiterbahnebene der ersten Busplatine 91 ausgebildet sein. Die Datenleitungen 163 können dann in im Inneren der ersten Busplatine 91 angeordneten Leiterbahnebenen ausgebildet sein, so dass die Datenleitungen 163 auf beiden Oberseiten der Busplatine 91 von der Massefläche 104 des Datenübertragungsmediums 160 abgeschirmt werden.

Bevorzugt sind die Dimensionen und gegenseitigen Abstände der Datenleitungen 163, sowie die Abstände der Datenleitungen 163 von der Massefläche 104 des Datenübertragungsmediums 160 so gewählt, dass die Datenleitungen 163 eines Datenkanals 161, 162 jeweils eine differentielle Impedanz von 100 Ohm aufweisen. Zwischen den Datenleitungen 163 können die Leiterbahnebenen im Inneren der ersten Busplatine 91, in welchen die Datenleitungen 163 angeordnet sind, zur besseren Abschirmung gegen elektromagnetische Störungen ebenfalls mit der Massefläche 104 belegt sein.

Die Datenleitungen 163 des ersten Datenkanals 161 und des zweiten Datenkanals 162 verbinden immer jeweils nur eines der Sendekontaktelemente 115, 116 eines der Modulanschlüsse 120, 130, 140, 145 mit einem der Empfangskontaktelemente 117, 118 eines anderen der Modulanschlüsse 120, 130, 140, 145. Insofern sind der erste Datenkanal 161, der zweite Datenkanal 162 und mit diesen auch das Datenübertragungsmedium 160 jeweils im Kommunikationssignalbereich 122 der Modulanschlüsse 120, 130, 140, 145 unterbrochen und es werden jeweils nur Direktverbindungen bzw. Punkt-zu-Punkt-Verbindungen zwischen den Modulanschlüssen 120, 130, 140, 145 realisiert. Das derart ausgestaltete Datenübertragungsmedium 160 kann beispielsweise als Feldbussystem fungieren und beispielsweise für eine E-Bus-Verbindung zwischen den Modulanschlüssen 120, 130, 140, 145 verwendet werden.

Über die Datenleitungen 163 des ersten Datenkanals 161 können Kommunikationsdaten von dem an den vierten Modulanschluss 145 angeschlossenen ersten Umsetzermodul 30 über das erste Steuerungsmodul 20 an dem ersten Modulanschluss 120 und über das zweite Steuerungsmodul 22 an dem zweiten Modulanschluss 130 an das dritte Steuerungsmodul 23 an dem dritten Modulanschluss 140 weitergeleitet werden. Dabei empfangen das erste Steuerungsmodul 20, das zweite Steuerungsmodul 22 und das dritte Steuerungsmodul 23 die Kommunikationsdaten jeweils über das an den ersten Datenkanal 161 angeschlossene erste und zweite Empfangskontaktelement 117, 118. Nach einer Verarbeitung der Kommunikationsdaten senden das erste Steuerungsmodul 20 und das zweite Steuerungsmodul 22 die Kommunikationsdaten jeweils über die an den ersten Datenkanal 161 angeschlossenen Sendekontaktelemente 115, 116 weiter.

Das dritte Steuerungsmodul 23 sendet die Kommunikationsdaten nach einem Empfang über die an den ersten Datenkanal 161 angeschlossenen Empfangskontaktelemente 117, 118 und einer Verarbeitung der Kommunikationsdaten über die an den zweiten Datenpfad 162 angeschlossenen Sendekontaktelemente 115, 116 zurück an das zweite Steuerungsmodul 22 an dem zweiten Modulanschluss 130. Über das zweite Steuerungsmodul 22 und das erste Steuerungsmodul 20 an dem ersten Modulanschluss 120 werden die Kommunikationsdaten anschließend über den zweiten Datenkanal 162 an das erste Umsetzermodul 30 zurückgesendet. Das erste Umsetzermodul 30 kann die Kommunikationsdaten anschließend über den übergeordneten Datenpfad 50 an den Steuerungsrechner 9 übermitteln. Insgesamt kann über den ersten Datenpfad 161 und den zweiten Datenpfad 162 des Datenübertragungsmediums 160 eine simultane, bidirektionale Kommunikation zwischen den Modulanschlüssen 120, 130, 140, 145 und den an diese angeschlossenen Modulen 20, 22, 23, 30 erfolgen.

Wie in Figur 2 dargestellt ist, werden die Kontaktelemente 110 der Feldsignalbereiche 123 der Modulanschlüsse 120, 130, 140, 145 von den Signalleitungen 171 des Signalübertragungsmediums 170 kontaktiert. Über die Signalleitungen 171 sind die Kontaktelemente der Feldsignalbereiche 123 mit den Feldanschlüssen 150, 155 verbunden. Beispielhaft verbindet eine der Feldsignalleitungen 171 eines der Kontaktelemente 110 des Feldsignalbereichs 123 des ersten Modulanschlusses 120 mit dem Feldanschluss 150. Ein weiteres der Kontaktelemente 110 des Feldsignalbereichs 123 des ersten Modulanschlusses 120 ist über eine weitere der Feldsignalleitungen 171 mit dem weiteren Feldanschluss 155 verbunden. Obwohl nicht dargestellt, können die restlichen Kontaktelemente 110 des Feldsignalbereichs 123 des ersten Modulanschlusses 120 ebenfalls über die Feldsignalleitungen 171 mit dem Feldanschluss 150 oder dem weiteren Feldanschluss 155 verbunden sein.

Analog können die Kontaktelemente 110 des Feldsignalbereichs 123 des zweiten Modulanschlusses 130 und des dritten Modulanschlusses 140 über die Signalleitungen 171 mit dem Feldanschluss 150 und dem weiteren Feldanschluss 155 verbunden sein. In Figur 2 stellt jeweils eine der Signalleitungen 171 eine Verbindung zwischen einem der Kontaktelemente 110 des Feldsignalbereichs 123 des zweiten Modulanschlusses 130 und dem Feldanschluss 150 bzw. dem weiteren Feldanschluss 155 her. Des Weiteren ist in Figur 2 eine Verbindung zwischen einem der Kontaktelemente 110 des Feldsignalbereichs 123 des dritten Modulanschlusses 140 und dem weiteren Feldsignalbereich 155 über eine der Signalleitungen 171 dargestellt.

Das erste Umsetzermodul 30 dient alleine der Umsetzung von Kommunikationsdaten von dem übergeordneten Datenpfad 50 auf das Datenübertragungsmedium 160 des ersten Kopplermoduls 100 und umgekehrt. Entsprechend ist an die Kontaktelemente 110 des Feldsignalbereichs 123 des den Umsetzermodulanschluss 146 darstellenden vierten Modulanschlusses 145 keine der Signalleitungen 171 des Signalübertragungsmediums 170 angeschlossen.

Auf dem Feldanschluss 150 werden Feldsignale des ersten Steuerungsmoduls 20 und des zweiten Steuerungsmoduls 22 zusammengefasst. Ein Feldgerät, welches die entsprechenden Feldsignale des ersten Steuerungsmoduls 20 und des zweiten Steuerungsmoduls 22 nutzt, muss lediglich an den Feldanschluss 150 angeschlossen werden. Dies kann beispielsweise mit einem einzelnen mehradrigen Kabel oder einem einzelnen Kabelstrang aus mehreren Kabeln erfolgen. Analog fasst der weitere Feldanschluss 155 Feldsignale des ersten Steuerungsmoduls 20, des zweiten Steuerungsmoduls 22 und des dritten Steuerungsmoduls 23 zusammen.

Wie in Figur 2 dargestellt ist, bilden insgesamt acht Kontaktelemente 110 die Spannungsversorgungsbereiche 124 der Modulanschlüsse 120, 130, 140 aus. Dabei sind drei der acht Kontaktelemente 110, nämlich die beiden an den Feldsignalbereich 123 angrenzenden Kontaktelemente 110 und ein weiteres neben diesen beiden Kontaktelemente 110 angeordnetes Kontaktelement 110, an eine der Spannungsleitungen der Feldspannungsversorgung 101 angeschlossen. Drei weitere, an die ersten drei Kontaktelemente 110 angrenzende Kontaktelemente 110 sind an die andere Spannungsleitung der Feldspannungsversorgung 101 angeschlossen. Die verbleibenden zwei Kontaktelemente 110 des Spannungsversorgungsbereichs 124, welche sich an einem dem Feldsignalbereich 123 abgewandten Rand des Spannungsversorgungsbereichs 124 befinden, sind mit einer Gehäusemasse der ersten Koppeleinheit 100 elektrisch leitend verbunden.

Der erste, zweite und dritte Modulanschluss 120, 130, 140 sind parallel an die Feldspannungsversorgung 101 angeschlossen. Die Kontaktelemente 110 des Spannungsversorgungsbereichs 124 des vierten Modulanschlusses 145 sind auf die gleiche Weise an die busseitige Spannungsversorgung 102 angeschlossen, wie die Kontaktelemente 110 der Spannungsversorgungsbereiche 124 des ersten, zweiten und dritten Modulanschlusses 120 an die Feldspannungsversorgung 101 angeschlossen sind.

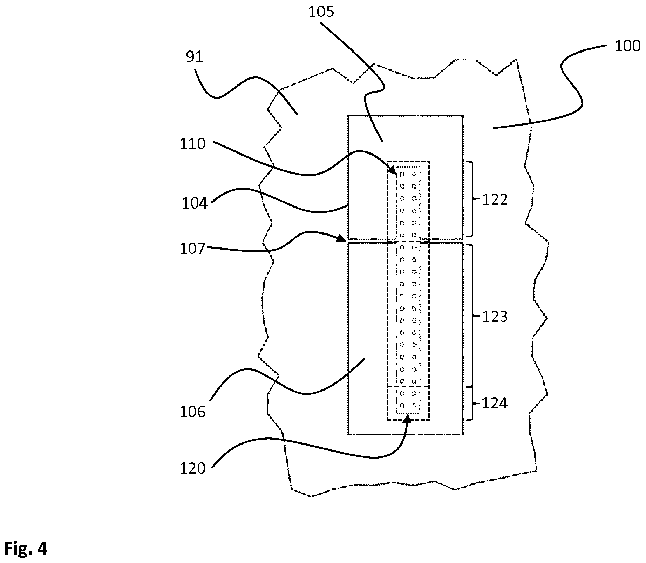

**Figur 4** zeigt beispielhaft eine Darstellung von Leiterbahnbereichen der ersten Busplatine 91 an dem ersten Modulanschluss 120. Der Kommunikationssignalbereich 122 des ersten Modulanschlusses 120 ist in einem Busleiterbereich 105 angeordnet. Der Busleiterbereich 105 umfasst alle Leiterbahnen des Datenübertragungsmediums 160. Hierzu zählen neben der Massefläche 104 unter anderem die Datenleitungen 163 und die Busspannungsleitung 103.

Die Kontaktelemente 110 des Feldsignalbereichs 123 und des Spannungsversorgungsbereichs 124 des ersten Modulanschlusses 120 sind in einem Feldleiterbereich 106 angeordnet. Der Feldleiterbereich 106 umfasst unter anderem die Leiterbahnen des Signalübertragungsmediums 170 mit den Signalleitungen 171 und die Leiterbahnen der Feldspannungsversorgung 101. Wie der Busleiterbereich 105 kann auch der Feldleiterbereich 106 von einer Massefläche, die auf einer der Oberflächen oder auf beiden Oberflächen der Busplatine 91 angeordnet sein kann, teilweise oder vollständig abgedeckt werden.

Der Busleiterbereich 105 und der Feldleiterbereich 106 erstreckt sich über alle Modulanschlüsse 120, 130, 140, 145 der ersten Busplatine 91. Die Kontaktelemente 110 des zweiten, dritten und vierten Modulanschlusses 130, 140, 145 sind jeweils wie die Kontaktelemente 110 des ersten Modulanschlusses 120 in dem Feldleiterbereich 106 und dem Busleiterbereich 105 angeordnet. Ebenso bildet die Massefläche 104 des Datenübertragungsmediums 160 eine zusammenhängende Massefläche aus, welche sich über alle Modulanschlüsse 120, 130, 140, 145 der Busplatine 91 der ersten Koppeleinheit 100 erstreckt.

Die Leiterbahnen des Busleiterbereich 105 und des Feldleiterbereichs 106 sind galvanisch getrennt voneinander ausgeführt. Die Leiterbahnen des Feldleiterbereichs 106 weisen jeweils wenigstens einen Abstand 107 von den Leiterbahnen des Busleiterbereichs 105. Der Abstand 107 bildet an den Modulanschlüssen 120, 130, 140, 145 einen Luftspalt beziehungsweise auf und in der ersten Busplatine 91 eine elektrische Kriechstrecke zwischen den Leitern des Feldleiterbereichs 106 und des Busleiterbereichs 105. Der Abstand 107 beträgt bevorzugt mehr als 0,5 mm, noch bevorzugter beträgt er 1,2 mm und stellt eine Spannungsfestigkeit von wenigstens 500 V her.

Bei einer alternativen Ausgestaltung der ersten Koppeleinheit 100 können die Modulanschlüsse 120, 130, 140, 145, die Feldanschlüsse 150, 155, das Datenübertragungsmedium 160 und das Signalübertragungsmedium 170 anstatt auf der ersten Busplatine 91 auch auf oder an einer anderen Trägereinrichtung ausgebildet sein. Beispielsweise kann die Koppeleinheit 100 als Trägereinrichtung ein Gehäuse, beispielsweise ein Kunststoff- oder Metallgehäuse, umfassen, an dem die Modulanschlüsse 120, 130, 140, 145 und die Feldanschlüsse 150, 155 angeordnet sind. Das Datenübertragungsmedium 160 und das Signalübertragungsmedium 170 können mittels an oder in dem Gehäuse angeordneten Leitungen, beispielsweise mittels Kabeln oder Drähten, realisiert werden. Entscheidend ist, dass die feldgerätespezifische Signalrangierung zwischen den Modulanschlüssen 120, 130, 140 und den Feldanschlüssen 150, 155 durch das Signalübertragungsmedium 170 der ersten Koppeleinheit 100 erfolgt.

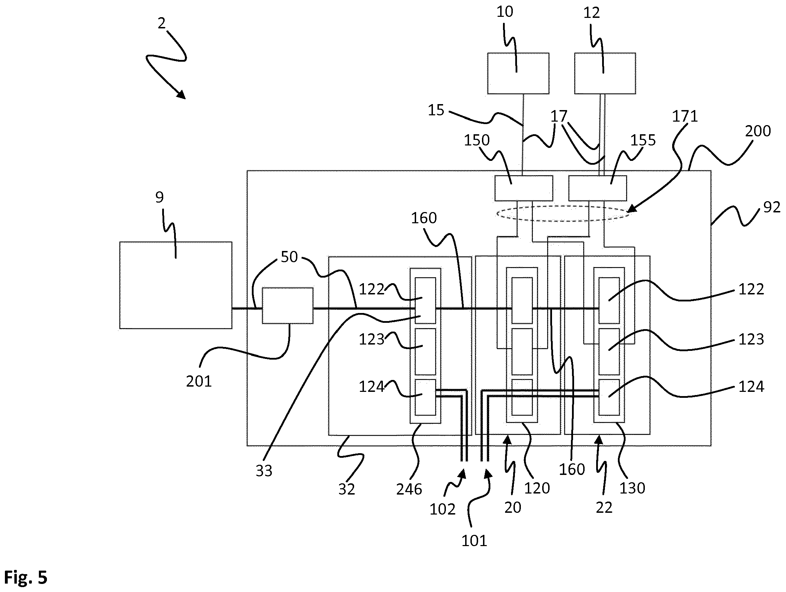

**Figur 5** zeigt eine schematische Darstellung eines zweiten industriellen Steuerungssystems 2 mit einer zweiten Koppeleinheit 200. Soweit keine Unterschiede beschrieben werden, sind das zweite industrielle Steuerungssystem 2 und die zweite Koppeleinheit 200 genauso ausgebildet wie das erste industrielle Steuerungssystem 1 beziehungsweise die erste Koppeleinheit 100. Insofern werden zumindest teilweise identische Bezugszeichen verwendet.

Die zweite Koppeleinheit 200 umfasst eine zweite Busplatine 92. Die zweite Busplatine 92 ist, soweit keine Unterschiede beschrieben werden, ausgebildet wie die erste Busplatine 91. Insbesondere weist die zweite Busplatine 92 den ersten Modulanschluss 120, den zweiten Modulanschluss 130, den Feldanschluss 150, den weiteren Feldanschluss 155, das Datenübertragungsmedium 160 und das Signalübertragungsmedium 170 auf.

Das zweite industrielle Steuerungssystem 2 umfasst weiterhin das erste Steuerungsmodul 20 und das zweite Steuerungsmodul 22. Anstatt des ersten Umsetzermoduls 30 ist an der zweiten Koppeleinheit 200 ein zweites Umsetzermodul 32 angeordnet. Das zweite Umsetzermodul 32 ist, soweit keine Unterschiede beschrieben werden, ausgebildet wie das erste Umsetzermodul 30. Insbesondere weist das zweite Umsetzermodul 32 ein Anschlusselement zur Verbindung mit einem weiteren Umsetzermodulanschluss 146 der zweiten Busplatine 92 auf. Anders als bei dem ersten Umsetzermodul 30 ist bei dem zweiten Umsetzermodul 32 die Schnittstelle 33 zu dem übergeordneten Datenpfad 50 in das Anschlusselement zu dem weiteren Umsetzermodulanschluss 246 integriert und die Schnittstelle 33 wird von dem weiteren Umsetzermodulanschluss 246 der zweiten Busplatine 92 kontaktiert.

Der weitere Umsetzermodulanschluss 246 der zweiten Koppeleinheit 200 ist, soweit keine Unterschiede beschrieben werden, ausgebildet und kontaktiert wie der als Umsetzermodulanschluss 146 fungierende vierte Modulanschluss 145 der ersten Koppeleinheit 100. Zur Kontaktierung der Schnittstelle 33 des zweiten Umsetzermoduls 32 ist ein Teil des übergeordneten Datenpfads 50 auf der zweiten Busplatine 92 der zweiten Koppeleinheit 200 angeordnet. Dieser Teil des übergeordneten Datenpfads 50 wird durch Leiterbahnen auf der zweiten Busplatine 92 ausgebildet.

Die zweite Busplatine 92 verfügt über eine Koppeleinrichtung 201, welche den auf der zweiten Busplatine 92 verlaufenden Teil des übergeordneten Datenpfads 50 mit dem restlichen übergeordneten Datenpfad 50 und dem Steuerungsrechner 9 verbindet. Die Koppeleinrichtung 201 kann beispielsweise eine oder mehrere Buchsen oder Stecker für Netzwerkkabel aufweisen. Beispielsweise kann die Koppeleinrichtung 201 zwei RJ-45 Buchsen aufweisen. Die Koppeleinrichtung 201 kann sich beispielsweise zusammen mit den Feldanschlüssen 150, 155 auf einer den Modulanschlüssen 120, 130, 246 gegenüberliegenden Seite der zweiten Busplatine 92 befinden.

Der auf der zweiten Busplatine 92 angeordnete Teil des übergeordneten Datenpfads 50 ist mit Kontaktelementen 110 im Kommunikationssignalbereich 122 des weiteren Umsetzermodulanschlusses 146 der zweiten Koppeleinheit 200 verbunden. Diese Kontaktelemente 110 können beispielsweise benachbart zu den an den ersten Datenkanal 161 angeschlossenen Sendekontaktelementen 115, 116 und den an den zweiten Datenkanal 162 angeschlossenen Empfangskontaktelementen 117, 118 angeordnet sein und sich in der Kontaktreihe neben den Sendekontaktelementen 115, 116 und Empfangskontaktelementen 117, 118 befinden.

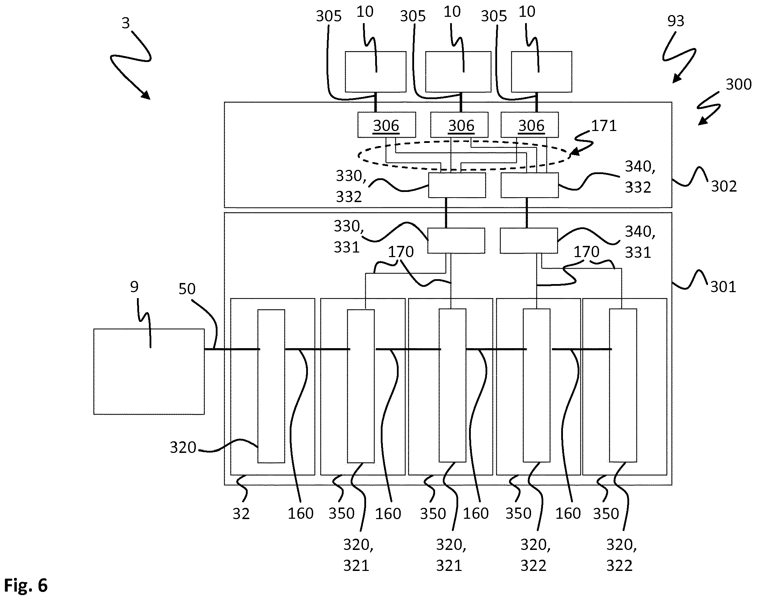

**Figur 6** zeigt ein drittes industrielles Steuerungssystem 3, welches eine dritte Koppeleinheit 300 mit einer dritten Busplatine 93 umfasst. Soweit keine Unterschiede beschrieben werden, sind das dritte industrielle Steuerungssystem 3, die dritte Koppeleinheit 300 und die dritte Busplatine 93 ausgebildet wie das erste und zweite Steuerungssystem 1, 2, die erste und zweite Koppeleinheit 100, 200 beziehungsweise die erste und zweite Busplatine 91, 92. Insofern werden zumindest teilweise identische Bezugszeichen verwendet.

Die dritte Busplatine 93 umfasst eine Modulanschlussplatine 301 und eine Feldanschlussplatine 302. Die Modulanschlussplatine 301 und die Feldanschlussplatine 302 können beispielsweise als zwei getrennte Leiterplatten ausgeführt sein. Auf der Modulanschlussplatine 301 sind Modulanschlüsse 320 angeordnet, welche wie der erste, zweite, dritte und vierte Modulanschluss 120, 130, 140, 145 der ersten Koppeleinheit 100 ausgebildet sind.

Auf der Feldanschlussplatine 302 sind drei Feldanschlüsse 360 angeordnet. Die Feldanschlüsse 360 sind wie die Feldanschlüsse 150, 155 ausgebildet und kontaktieren über jeweils ein Feldsignalübertragungsmedium 305 jeweils eines der industriellen Feldgeräte 10. Die Feldsignalübertragungsmedien 305 sind ausgeführt wie die Feldsignalübertragungsmedien 15 und können insbesondere eine unterschiedliche Anzahl von Feldsignalleitungen 17 aufweisen.

Die Modulanschlussplatine 301 und die Feldanschlussplatine 302 sind über ein erstes Verbindungselement 330 und ein zweites Verbindungselement 340 elektrisch leitend miteinander verbunden. Bei den Verbindungselementen 330, 340 kann es sich beispielsweise um elektrische Steckverbindungen handeln. In Figur 6 ist ein Stecker 331 des ersten Verbindungselements 330 auf der Modulanschlussplatine 301 und eine zu dem Stecker 331 passende Buchse 332 auf der Feldanschlussplatine 302 angeordnet. Der Stecker 331 des zweiten Verbindungselements 340 ist ebenso auf der Modulanschlussplatine 301, die Buchse 332 des zweiten Verbindungselements 340 auf der Feldanschlussplatine 302 angeordnet.

Das erste Verbindungselement 330 und das zweite Verbindungselement 340 können neben der elektrischen auch eine mechanische Verbindung zwischen der Modulanschlussplatine 301 und der Feldanschlussplatine 302 herstellen. Die Stecker 331 des ersten und des zweiten Verbindungselements 330, 340 können auch auf der Feldanschlussplatine 302 und die Buchsen 332 auf der Modulanschlussplatine 301 angeordnet sein. Auch können nur ein Verbindungselement oder mehr als die zwei Verbindungselemente 330, 340 für die Verbindung zwischen der Modulanschlussplatine 301 und der Feldanschlussplatine 302 verwendet werden.

Die dritte Koppeleinheit 300 verfügt insgesamt über fünf Modulanschlüsse 320 auf der Modulanschlussplatine 301. Die Modulanschlüsse 320 sind, wie im Zusammenhang mit der ersten Koppeleinheit 100 und der zweiten Koppeleinheit 200 beschrieben, über das Datenübertragungsmedium 160 miteinander verbunden. Insbesondere kontaktieren die Modulanschlüsse 320 das Datenübertragungsmedium 160 so, wie es in Figur 3 dargestellt ist. Vier der Modulanschlüsse 320 kontaktieren, wie ebenfalls im Zusammenhang mit der ersten und der zweiten Koppeleinheit 100, 200 beschrieben, jeweils ein Steuerungsmodul 350. Die Steuerungsmodule 350 sind wie das erste, das zweite und das dritte Steuerungsmodul 20, 22, 23 ausgebildet. Das bereits im Zusammenhang mit dem zweiten industriellen Steuerungssystem 2 beschriebene Umsetzermodul 32 ist an den fünften der Modulanschlüsse 320 angeschlossen und kontaktiert über den teilweise auf der Modulanschlussplatine 301 ausgebildeten übergeordneten Datenübertragungspfad 50 den Steuerungsrechner 9.

Die Feldsignalbereiche 123 der Modulanschlüsse 320 sind über das Signalübertragungsmedium 170 mit den Verbindungselementen 330, 340 verbunden. Entsprechend der Anzahl von Kontaktelementen 110 der Feldsignalbereiche 123 können für die Verbindung pro Modulanschluss 320 bis zu sechzehn Signalleitungen 171 eingesetzt werden. Eine erste Gruppe 321 von Modulanschlüssen 320, welche aus zwei benachbarten Modulanschlüssen 320 bestehen kann, ist über das Signalübertragungsmedium 170 der dritten Koppeleinheit 300 mit dem ersten Verbindungselement 330 elektrisch leitend verbunden. Eine zweite Gruppe 322 von Modulanschlüsse 320, welche aus den übrigen beiden, ebenfalls benachbarten Modulanschlüssen 320 besteht, ist über das Signalübertragungsmedium 170 mit dem zweiten Verbindungselement 340 elektrisch leitend verbunden.

Die Verbindungselemente 330, 340 übertragen die Feldsignale von der Modulanschlussplatine 301 auf die Feldanschlussplatine 302. Auf der Feldanschlussplatine 302 werden die Feldsignale über die dort angeordneten Signalleitungen 171 an die Feldanschlüsse 360 verteilt. Eine feldgerätespezifische Signalrangierung erfolgt erst auf der Feldanschlussplatine 302. Auf der Modulanschlussplatine 301 werden alle Feldsignale der ersten Gruppe 321 von Modulanschlüssen 320 zu dem ersten Verbindungselement 330 und alle Feldsignale der zweiten Gruppe 322 von Modulanschlüsse 320 zu dem zweiten Verbindungselement 340 geleitet. Wird bei einer Neukonfiguration des dritten industriellen Steuerungssystems 3 eine Änderung der Signalrangierung notwendig, so muss lediglich die Feldanschlussplatine 302 ausgetauscht werden und die Modulanschlussplatine 301 kann in dem dritten industriellen Steuerungssystem 3 belassen werden.

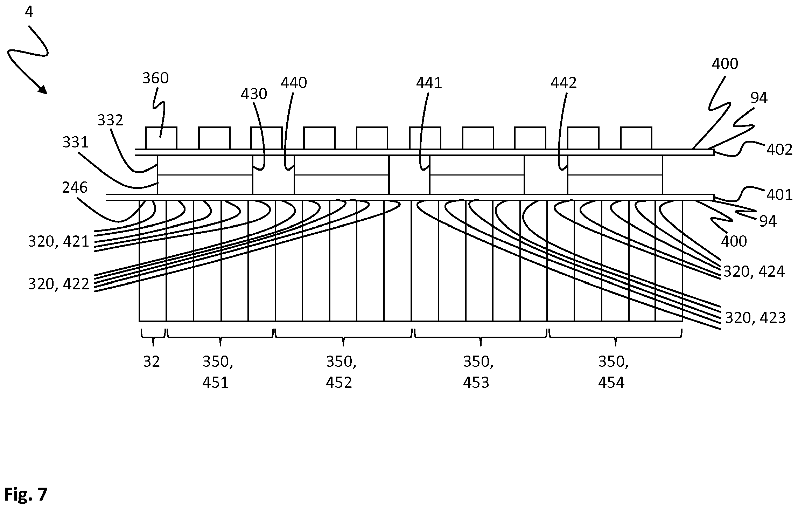

**Figur 7** zeigt eine Aufsicht einer vierten Koppeleinheit 400 eines viertens industriellen Steuerungssystems 4. Soweit keine Unterschiede beschrieben werden, ist das vierte industrielle Steuerungssystem 4 ausgebildet wie das dritte industrielle Steuerungssystem 3. Die vierte Koppeleinheit 400 umfasst eine vierte Busplatine 94. Wie die dritte Busplatine 93 umfasst die vierte Busplatine 94 eine Modulanschlussplatine 401 und eine Feldanschlussplatine 402. Die Modulanschlussplatine 401 und die Feldanschlussplatine 402 sind mit einem ersten Verbindungselement 430, einem zweiten Verbindungselement 440, einem dritten Verbindungselement 441 und einem vierten Verbindungselement 442 elektrisch leitend miteinander verbunden. Die Verbindungselemente 430, 440, 441, 442 sind, soweit keine Unterschiede beschrieben werden, ausgebildet wie die Verbindungselemente 330, 340 der dritten Koppeleinheit 300. Insbesondere umfassen sie jeweils den Stecker 331 und die Buchse 332.

An der Modulanschlussplatine 401 sind insgesamt zwanzig der Modulanschlüsse 320 angeordnet. Die Feldsignalebereiche der Modulanschlüsse 320 sind auf der Modulanschlussplatine 401 jeweils über das Signalübertragungsmedium der vierten Koppeleinheit 400 mit den Verbindungselementen 430, 440, 441, 442 elektrisch leitend verbunden. Auf der Feldanschlussplatine 402 stellt das Signalübertragungsmedium der vierten Koppeleinheit 400 einen elektrisch leitenden Kontakt zwischen den Verbindungselementen 430, 440, 441, 442 und insgesamt zehn der Feldanschlüsse 360 her.

Die zwanzig Modulanschlüsse 320 bilden eine erste Gruppe 421, eine zweite Gruppe 422, eine dritte Gruppe 423 und eine vierte Gruppe 424 von jeweils fünf benachbart angeordneten Modulanschlüssen 320. Die Kontaktelemente der Feldsignalbereiche der ersten Gruppe 421 von Modulanschlüssen 320 sind mit dem ersten Verbindungselement 430 elektrisch leitend verbunden. Entsprechend sind die Feldsignalbereiche der Modulanschlüsse 320 der zweiten Gruppe 422, der dritten Gruppe 423 und der vierten Gruppe 424 jeweils mit dem zweiten Verbindungselement 440, dem dritten Verbindungselement 441 beziehungsweise dem vierte Verbindungselement 442 elektrisch leitend verbunden. Wie bei der dritten Koppeleinheit 300 erfolgt eine feldgerätespezifische Signalrangierung auf der Feldanschlussplatine 402.

Das vierte industrielle Steuerungssystem 4 umfasst neunzehn der Steuerungsmodule 350 und das Umsetzermodul 32. Die Steuerungsmodule 350 und das Umsetzermodul 32 sind in einer Reihe nebeneinander an der Modulanschlussplatine 401 angeordnet und kontaktieren die Modulanschlüsse 320. Der Modulanschluss 320, an den das an einem Ende der Reihe platzierte Umsetzermodul 32 angeschlossen ist, bildet den weiteren Umsetzermodulanschluss 246. Die verbliebenen vier Modulanschlüsse 320 der ersten Anzahl 421 von Modulanschlüssen 320 sind jeweils mit einem der Steuerungsmodule 350 belegt.

Die vier an die erste Anzahl 421 von Modulanschlüssen 320 angeschlossenen Steuerungsmodule 350 bilden eine erste Gruppe 451 von Steuerungsmodulen 350, deren Feldsignale über das erste Verbindungselement 430 an die Feldanschlüsse 360 übertragen werden. Analog bilden die fünf an die zweite Anzahl 422 von Modulanschlüssen 320 angeschlossenen Steuerungsmodule 320 eine zweite Gruppe 452 von Steuerungsmodulen 320, deren Feldsignale über das zweite Verbindungselement 440 an die Feldanschlüsse 360 übertragen werden. Die fünf an die dritte Anzahl 423 von Modulanschlüssen 320 angeschlossenen Steuerungsmodule 350 bilden eine dritte Gruppe 453 von Steuerungsmodulen 320, die fünf an die vierte Anzahl 424 von Modulanschlüssen 320 angeschlossenen Steuerungsmodule 350 eine vierte Gruppe 454 von Steuerungsmodulen 350. Die Feldsignale der dritten Gruppe 453 von Steuerungsmodulen 350 werden über das dritte Verbindungselement 441, die Feldsignale der vierten Gruppe 454 von Steuerungsmodulen 350 über das vierte Verbindungselement 442 an die Feldanschlüsse 360 übertragen.

Die Feldanschlussplatine 402 und die Modulanschlussplatine 401 sind parallel zueinander angeordnet, wobei die Feldanschlussplatine 402 an einer Rückseite der vierten Koppeleinheit 400, die Modulanschlussplatine 401 an einer Vorderseite der vierten Koppeleinheit 400 angeordnet ist. Damit können Feldsignalübertragungsmedien an einer Seite der Koppeleinheit 400 angeschlossen werden, die Steuerungsmodule 350 und das Umsetzermodul 32 auf der anderen Seite der Koppeleinheit 400.

Anstatt die erste, zweite, dritte und vierte Anzahl 421, 422, 423, 424 jeweils aus fünf der Modulanschlüsse 320 zu bilden, können auch die Feldsignale einer größeren oder kleinen Zahl von Modulanschlüssen 320 auf einem der Verbindungselemente 330, 340, 341, 342 zusammengefasst werden. Auch können jeweils die Feldsignale einer unterschiedlichen Zahl von Modulanschlüssen 320 auf den verschiedenen Verbindungselementen 330, 340, 341, 342 zusammengefasst werden.

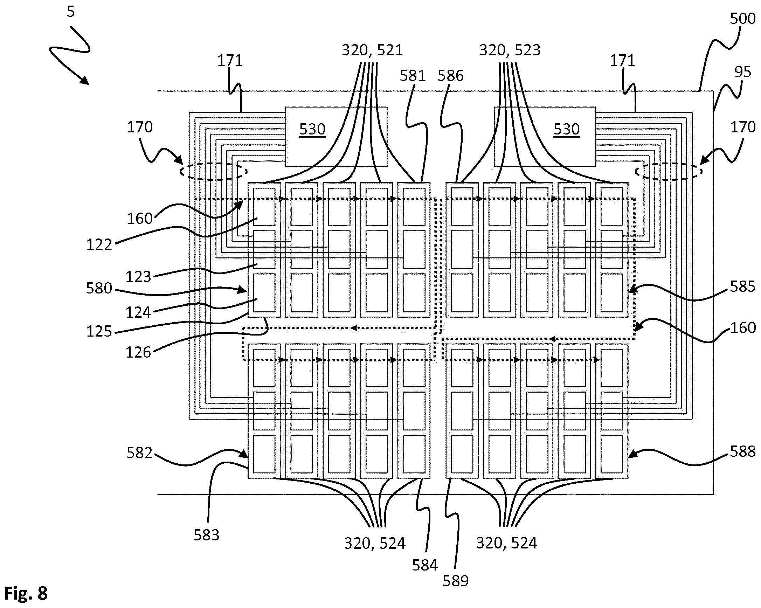

Die Modulanschlüsse 320 können auch mehrreihig an der Koppeleinheit angeordnet sein. In **Figur 8** ist ein Ausschnitt einer fünften Koppeleinheit 500 eines fünften industriellen Steuerungssystems 5 mit einer fünften Busplatine 95 dargestellt. Soweit keine Unterschiede beschrieben werden, sind das fünfte industrielle Steuerungssystem 5, die fünfte Koppeleinheit 500 und die fünfte Busplatine 95 ausgebildet wie das vierte Steuerungssystem 4, die vierte Koppeleinheit 400 beziehungsweise die vierte Busplatine 94.

Auf der fünften Busplatine 95 sind die Modulanschlüsse 320 in mehreren Reihen übereinander und nebeneinander angeordnet. Dabei bilden jeweils fünf der Modulanschlüsse 320 eine erste Anzahl 521, eine zweite Anzahl 522, eine dritte Anzahl 523 und eine vierte Anzahl 524 von Modulanschlüssen 320.

Die erste Anzahl 521 von Modulanschlüssen 320 ist in einer ersten Reihe 580, die zweite Anzahl 522 von Modulanschlüssen 320 ist in einer zweiten Reihe 582, die dritte Anzahl 523 von Modulanschlüssen 320 ist in einer dritten Reihe 585 und die vierte Anzahl 524 von Modulanschlüssen 320 ist in einer vierten Reihe 588 angeordnet. Dabei sind jeweils die langen Seiten 125 der Modulanschlüsse 320 parallel zueinander und voneinander beabstandet angeordnet. Die kurzen Seiten 126 der Modulanschlüsse 320 einer der Reihen 580, 582, 585, 588 sind jeweils fluchtend ausgerichtet.

Die erste, zweite, dritte und vierte Reihe 580, 582, 585, 588 sind jeweils parallel zueinander ausgerichtet. Die zweite Reihe 582 und die erste Reihe 580 von Modulanschlüssen 320 sind derart auf der fünften Busplatine 95 angeordnet, dass jeweils eine der kurzen Seiten 126 der Modulanschlüsse 320 der ersten und der zweiten Reihe 580, 582 einander zugewandt sind. Außerdem ist die zweite Reihe 582 von Modulanschlüssen 320 unter der ersten Reihe 580 angeordnet. An die erste Reihe 580 mit einem Abstand anschließend ist die dritte Reihe 585 und an die zweite Reihe 582 anschließend ist die vierte Reihe 588 angeordnet. Damit ist die vierte Reihe 588 unter der dritten Reihe 585 angeordnet.

Wie bei der ersten, zweiten, dritten und vierten Koppeleinheit 100, 200, 300, 400 sind die Modulanschlüsse 320 über das Datenübertragungsmedium 160 der fünften Koppeleinheit 500 miteinander verbunden. Dabei sind die Modulanschlüsse 320 der Reihen 580, 582, 585, 588 jeweils ausgehend von einem ersten kontaktierten Modulanschluss den Reihen 580, 582, 585, 588 nach bis zu einem letzten kontaktierten Modulanschluss durch das Datenübertragungsmedium 160 verbunden.

Ein letzter kontaktierter Modulanschluss 581 der ersten Reihe 580 ist auf der Seite der ersten Reihe 580 angeordnet, an die die dritte Reihe 585 von Modulanschlüssen 320 angrenzt und ein letzter kontaktierter Modulanschluss 584 der zweiten Reihe 582 ist unter dem letzten kontaktierten Modulanschluss 581 der ersten Reihe 580 angeordnet. Ein erster kontaktierter Modulanschluss 583 der zweiten Reihe 582 befindet sich auf der dem letzten kontaktierten Modulanschluss 584 der zweiten Reihe 582 gegenüberliegenden Seite der zweiten Reihe 582. Über das Datenübertragungsmedium 160 sind der letzte kontaktierte Modulanschluss 581 der ersten Reihe 580 und der erste kontaktierte Modulanschluss 583 der zweiten Reihe 582 elektrisch leitend miteinander verbunden.

Analog zu der ersten und der zweiten Reihe 580, 582 sind die Modulanschlüsse 320 der dritten und der vierten Reihe 585, 588 über das Datenübertragungsmedium 160 miteinander verbunden. Ein erster kontaktierter Modulanschluss 586 der dritten Reihe 585 ist auf der Seite der dritten Reihe 585 angeordnet, welche der ersten Reihe 580 zugewandt ist. Auf der gegenüberliegenden Seite der dritten Reihe 585 liegt ein letzter kontaktierter Modulanschluss 587 der dritten Reihe 585. Unter dem ersten kontaktierten Modulanschluss 586 der dritten Reihe 585 liegt ein erster kontaktierter Modulanschluss 589 der vierten Reihe 588. Der Kommunikationssignalbereich 122 des letzten kontaktierten Modulanschlusses 587 der dritten Reihe 585 ist über das Datenübertragungsmedium 160 mit dem Kommunikationssignalbereich 122 des ersten kontaktierten Modulanschlusses 589 der vierten Reihe 588 von Modulanschlüssen 320 verbunden.

Auf dem Datenübertragungsmedium 160 übertragene Kommunikationsdaten können zunächst an die Modulanschlüsse 320 der ersten Reihe 380, anschließend an die Modulanschlüsse 320 der zweiten Reihe 582, die Modulanschlüsse 320 der dritten Reihe 585 und schließlich an die Modulanschlüsse 320 der vierten Reihe 588 übertragen werden. Dabei können die Kommunikationsdaten die Modulanschlüsse 320 der einzelnen Reihen 380, 382, 385, 388 jeweils in der gleichen Richtung durchlaufen.

Die Kontaktelemente 110 der Feldsignalbereiche 123 der Modulanschlüsse 320 der ersten Reihe 580 und der zweiten Reihe 582 sind jeweils alle über das Signalübertragungsmedium 170 mit einem ersten Verbindungselement 530 verbunden. Die Kontaktelemente 110 der Feldsignalbereiche 123 der Modulanschlüsse 320 der dritten und der vierten Reihe 585, 588 sind über das Signalübertragungsmedium 170 mit einem zweiten Verbindungselement 540 verbunden. Es müssen nicht alle Kontaktelemente 110 der Feldsignalbereiche 123 mit einem der Verbindungselemente 530, 540 verbunden sein. Soweit keine Unterschiede beschrieben werden, sind das erste Verbindungselement 530 und das zweite Verbindungselement 540 der fünften Koppeleinheit 500 wie die Verbindungselemente 330, 340, 430, 440, 441, 442 der dritten und der vierten Koppeleinheit 300, 400 ausgebildet. Das erste Verbindungselement 530 ist auf der der zweiten Reihe 582 gegenüberliegenden Seite der ersten Reihe 580 von Modulanschlüssen 320 angeordnet. Analog ist das zweite Verbindungselement 540 auf der der vierten Reihe 588 gegenüberliegenden Seite der dritten Reihe 585 von Modulanschlüssen 320 angeordnet.

Die fünfte Koppeleinheit 500 kann weitere Reihen von Modulanschlüssen 320 und Verbindungselementen umfassen. Beispielsweise können eine oder mehrere Anschlussblöcke auf der fünften Busplatine 95 angeordnet werden, welche jeweils zwei Reihen von Modulanschlüssen 320 und ein Verbindungselement umfassen. Die beiden Reihen von Modulanschlüssen 320 und das Verbindungselement können beispielsweise so auf der fünften Busplatine 95 angeordnet sein, wie die erste und zweite Reihe 580, 582 von Modulanschlüssen 320 und das erste Verbindungselement 530, beziehungsweise wie die dritte und vierte Reihe 585, 588 und das zweite Verbindungselement 540. Damit sind die Modulanschlüsse 320 und das Verbindungselement eines Anschlussblocks benachbart zueinander angeordnet. Durch eine regelmäßige Wiederholung dieser Anschlussblöcke kann auf einfache Weise ein Platinenlayout um zusätzlichen Modulanschlüsse 320 und Verbindungelemente erweitert werden.

Die Reihen 580, 582, 585, 588 können auch eine geringere oder größere Zahl von Modulanschlüssen 320 umfassen. Auch können die Modulanschlüsse 320 von nur einer oder von mehr als zwei Reihen über das Signalübertragungsmedium 170 mit einem Verbindungselement zu der Feldanschlussplatine 402 verbunden sein.

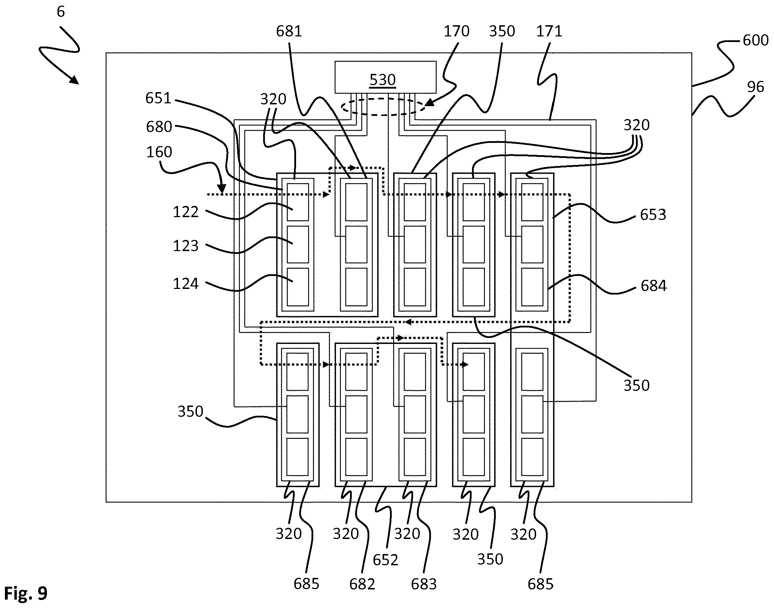

Ein industrielles Steuerungssystem kann auch Steuerungsmodule umfassen, welche mehr als einen Modulanschluss kontaktieren. **Figur 9** zeigt einen Ausschnitt einer sechsten Koppeleinheit 600 eines sechsten industriellen Steuerungssystems 6 mit einer sechsten Busplatine 96. Soweit keine Unterschiede beschrieben werden, sind das sechste industrielle Steuerungssystem 6, die sechste Koppeleinheit 600 und die sechste Busplatine 96 ausgebildet wie das fünfte Steuerungssystem 5, die fünfte Koppeleinheit 500 beziehungsweise die fünfte Busplatine 95.

Auf der sechsten Busplatine 96 sind zehn der Modulanschlüsse 320 in zwei Reihen nebeneinander angebracht. Die beiden Reihen sind übereinander an der sechsten Busplatine 96 des sechsten Koppelmoduls 600 angeordnet. An vier der Modulanschlüsse 320 ist jeweils eines der Steuerungsmodule 350 angeschlossen. Neben den Steuerungsmodulen 350 umfasst das sechste industrielle Steuerungssystem 6 ein breites Steuerungsmodul 651. Das breite Steuerungsmodul 651 ist ausgebildet wie die Steuerungsmodule 20, 22, 23, 350 des ersten, zweiten, dritten und vierten Steuerungssystems 1, 2, 3, 4, weist jedoch verglichen mit diesen eine doppelt so große Breite auf und ist dazu ausgebildet, zwei Modulanschlüsse 320 anstatt nur eines Modulanschlusses 320 zu kontaktieren.

An der sechsten Busplatine 96 kontaktiert das breite Steuerungsmodul 651 einen fünften Modulanschluss 680 und einen in derselben Reihe neben dem fünften Modulanschluss 680 angeordneten sechsten Modulanschluss 681. Der fünfte und der sechste Modulanschluss 680, 681 sind ausgebildet und kontaktiert wie die Modulanschlüsse 120, 130, 140, 145, 320 der ersten, zweiten, dritten und vierten Koppeleinheit 100, 200, 300, 400.

Das breite Steuerungsmodul 651 kann beispielsweise über den fünften Modulanschluss 680 das Datenübertragungsmedium 160 und über den sechsten Modulanschluss 681 das Signalübertragungsmedium 170 kontaktieren. Werden zur Übertragung der Feldsignale mehr Kontaktelemente 110 benötigt, als der Feldsignalbereich 123 des sechsten Modulanschlusses 681 umfasst, können zusätzlich die Kontaktelemente 110 des Feldsignalbereichs 123 des fünften Modulanschlusses 680 zur Übertragung von Feldsignalen kontaktiert werden. Dies ist bei einem weiteren breiten Steuerungsmodul 652, welches an der unteren Reihe von Modulanschlüssen 320 angeordnet ist und einen siebten Modulanschluss 682 und einen achten Modulanschluss 683 kontaktiert, der Fall. Der siebte und der achte Modulanschluss 680, 681 sind ausgebildet und kontaktiert wie die Modulanschlüsse 120, 130, 140, 145, 320 der ersten, zweiten, dritten und vierten Koppeleinheit 100, 200, 300, 400.

Das breite Steuerungsmodul 651 kann beispielsweise als Motoranschlussmodul zu Ansteuerung eines Motors oder Antriebs mit einem vergleichsweise hohen Strom ausgebildet sein. Um die Modulanschlüsse 680, 681 nicht zu überlasten, können mehrere Kontaktelemente 110 parallel zur Übertragung des Antriebsstroms verwendet werden. Da das Datenübertragungsmedium 160 den Kommunikationssignalbereich 122 des sechsten Modulanschlusses 681 nicht kontaktiert, ist es im Bereich des sechsten Modulanschlusses 681 um die Kontaktelemente 110 des Kommunikationssignalbereichs 122 herumgeführt.

Das sechste industrielle Steuerungssystem 6 umfasst weiterhin ein hohes Steuerungsmodul 653. Das hohe Steuerungsmodul ist ausgebildet wie die Steuerungsmodule 20, 22, 23, 350 des ersten, zweiten, dritten und vierten Steuerungssystems 1, 2, 3, 4, weist jedoch verglichen mit diesen eine in etwa doppelt so große Höhe auf. Das hohe Steuerungsmodul 653 verfügt über zwei übereinander angeordnete Anschlusselemente, über welche es einen neunten Modulanschluss 684 und einen zehnten Modulanschluss 685 der sechsten Koppeleinheit 600 elektrisch leitend kontaktiert. Der neunte Modulanschluss 684 und der zehnte Modulanschluss 685 sind übereinander liegend in jeweils einer der beiden Reihen von Modulanschlüssen 320 angeordnet und ausgebildet wie die Modulanschlüsse 120, 130, 140, 145, 320 der ersten, zweiten, dritten und vierten Koppeleinheit 100, 200, 300, 400.

Über den neunten Modulanschluss 684 kontaktiert das hohe Steuerungsmodul 652 das Datenübertragungsmedium 160 der sechsten Koppeleinheit 600. Alternativ kann das hohe Steuerungsmodul 653 das Datenübertragungsmedium 160 auch über den zehnten Modulanschluss 685 oder über den neunten Modulanschluss 684 sowie den zehnten Modulanschluss 685 kontaktieren. Das hohe Steuerungsmodul 653 kontaktiert über die Feldsignalbereiche 123 sowohl des neunten Modulanschlusses 684, als auch des zehnten Modulanschlusses 685 das Signalübertragungsmedium 170 der sechsten Koppeleinheit 600. Je nach Ausgestaltung des hohen Steuerungsmoduls 653 und der Anzahl der für die Feldsignalübertragung benötigten Kontaktelemente 110 kann das hohe Steuerungsmodul 653 das Signalübertragungsmedium 170 auch nur über den neunten oder den zehnten Modulanschluss 684, 685 kontaktieren.

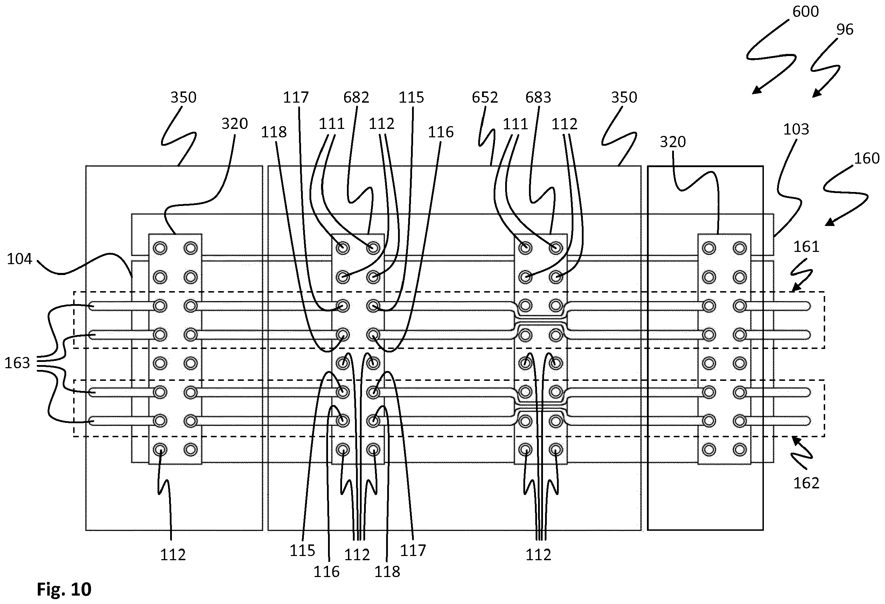

In **Figur 10** ist ein Ausschnitt des Datenübertragungsmediums 160 der sechsten Busplatine 96 der sechsten Koppeleinheit 600 im Bereich des weiteren breiten Steuerungsmoduls 652 näher dargestellt. Wie im Zusammenhang mit der ersten Busplatine 91 der ersten Koppeleinheit 100 beschrieben wird, umfasst das Datenübertragungsmedium 160 den ersten und den zweiten Datenkanal 161, 162. Weiterhin umfasst das Datenübertragungsmedium 160 die Busspannungsleitung 103 und die Massefläche 104. Soweit nicht anders beschrieben, kontaktieren die Modulanschlüsse 320, 680, 681, 682, 683, 684, 685 das Datenübertragungsmedium 160 wie in Zusammenhang mit Figur 3 beschrieben. Im Unterschied zu Figur 3 werden jedoch der sechste Modulanschluss 681, der achte Modulanschluss 683 und der zehnte Modulanschluss 685 nicht von den Datenleitungen 163 des Datenübertragungsmediums 160 kontaktiert.

Der in Figur 10 dargestellte siebte Modulanschluss 682, an den eines der Anschlusselemente des weiteren breiten Steuerungsmoduls 652 angeschlossen ist, verfügt wie der erste Modulanschluss 120 der ersten Busplatine 91 über Sendekontaktelemente 115, 116 und Empfangskontaktelemente 117, 118. Auf die gleiche Weise, wie der erste Modulanschluss 120 mit dem vierten Modulanschluss 145 und dem zweiten Modulanschluss 130 verbunden ist, sind die Sendekontaktelemente 115, 116 und die Empfangskontaktelemente 117, 118 des siebten Modulanschlusses 682 mit dem neben dem siebten Modulanschluss 682 und dem achten Modulanschluss 683 angeordneten Modulanschlüssen 320 verbunden.

Der achte Modulanschluss 683 wird nicht zur Datenübertragung genutzt. Daher werden die Datenleitungen 163 des ersten und des zweiten Datenkanals 161, 162 zwischen den Kontaktelementen 110 des achten Modulanschlusses 683 hindurchgeführt, ohne diese Kontaktelemente 110 elektrisch zu kontaktieren. Die Datenleitungen 163 sind dabei zwischen den Kontaktelementen 110 angeordnet, welche bei an das Datenübertragungsmedium 160 angeschlossenen Modulanschlüssen 320, 680, 682, 684 als Sendekontaktelement 115 und weiteres Sendekontaktelement 116, beziehungsweise als Empfangskontaktelement 117 und weiteres Empfangskontaktelement 118 fungieren. Die nicht belegten Kontaktelemente 110 des achten Modulanschlusses 683 können entweder überhaupt nicht kontaktiert werden, oder die Massefläche 104 kontaktieren. Auf analoge Weise können die Datenleitungen 163 an den Kontaktelementen 110 des sechsten und zehnten Modulanschlusses 681, 685 vorbeigeführt werden, ohne diese zu kontaktieren.

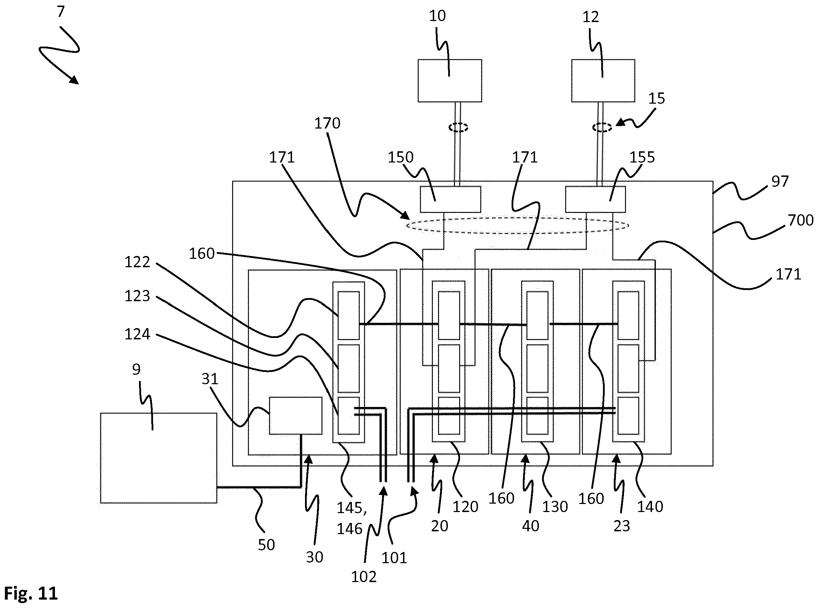

Umfasst das industrielle Steuerungssystem weniger Steuerungsmodule, als Modulanschlüsse auf der Koppeleinheit zur Verfügung stehen, so können an den freien Modulanschlüssen Platzhaltermodule angeordnet werden, um eine Weiterleitung der Kommunikationsdaten zu ermöglichen. In **Figur 11** ist ein siebtes industrielles Steuerungssystem 7 dargestellt, welches eine siebte Koppeleinheit 700 mit einer siebten Busplatine 97 umfasst. Soweit keine Unterschiede beschrieben werden, sind das siebte industrielle Steuerungssystem 7, die siebte Koppeleinheit 700 und die siebte Busplatine 97 ausgebildet wie das erste industrielle Steuerungssystem 1, die erste Koppeleinheit 100 und die erste Busplatine 91.

Anstatt des zweiten Steuerungsmoduls 22 ist an dem zweiten Modulanschluss 120 der siebten Koppeleinheit 700 ein Platzhaltermodul 40 angeordnet. Das Platzhaltermodul 40 ist, soweit keine Unterschiede beschrieben werden, ausgebildet wie das erste, zweite und dritte Steuerungsmodul 20, 22, 23. Wie diese Steuerungsmodule 20, 22, 23 ist das Platzhaltermodul 40 insbesondere dazu ausgebildet, Kommunikationsdaten über den Datenübertragungsmedium 160 von dem ersten Steuerungsmodul 20 oder dem dritten Steuerungsmodul 23 zu empfangen und die Kommunikationsdaten an das jeweils andere der Steuerungsmodule 20, 23 weiterzuleiten. Allerdings ist das Platzhaltermodul 40 nicht dazu ausgebildet, Feldsignale über die Kontaktelemente 110 des Feldsignalbereichs 123 des zweiten Modulanschlusses 130 zu übertragen. Es ist auch nicht dazu ausgebildet, eingelesene Feldsignale in Kommunikationsdaten umzusetzen beziehungsweise Feldsignale auf Grundlage von verarbeiteten Kommunikationsdaten zu erzeugen.

Das Platzhaltermodul 40 gewährleistet, dass Kommunikationsdaten auf dem im Bereich des zweiten Modulanschlusses 130 unterbrochenen Datenübertragungsmediums 160 von dem ersten Steuerungsmodul 20 an das dritte Steuerungsmodul 23 und umgekehrt übertragen werden können. Hierzu kann das Platzhaltermodul 40 dazu ausgebildet sein, von den Steuerungsmodulen 20, 23 empfangene Datensignale vor eine Weiterleitung zu verstärken und/oder zu glätten, um eine fehlerfreie Übertragung der Kommunikationsdaten zu ermöglichen.

Der Steuerungsrechner 9 kann dazu ausgebildet sein, die Anzahl der auf der siebten Busplatine 7 vorhandenen Modulanschlüsse 120, 130, 140, 145 und die Art der an diese Modulanschlüsse 120, 130, 140, 145 angeschlossenen Module 20, 23, 30, 40 abzufragen. Dies kann beispielsweise im Rahmen einer Initialisierung des siebten industriellen Steuerungssystems 7 erfolgen. Eine Abfrage von Anzahl und Art der Belegung der vorhandenen Modulanschlüsse 120, 130, 140, 145 kann beispielsweise erfolgen, indem der Steuerungsrechner 9 über das Umsetzermodul 31 Kommunikationsdaten an die Steuerungsmodule 20, 23 und das Platzhaltermodul 40 versendet, in welche die Module 20, 23, 40 modulspezifische Kennungen einfügen. Die modulspezifischen Kennungen können beispielsweise anzeigen, ob es sich bei den Modulen um eines der Steuerungsmodule 20, 23 oder das Platzhaltermodul 40 handelt. Die Steuerungsmodule 20, 23 können zusätzlich individuelle Kennungen in die Kommunikationsdaten einfügen, um beispielsweise anzuzeigen, ob es sich um ein Eingabe- oder Ausgabemodul oder um ein digitales oder analoges Modul handelt. Schließlich können auch Kennungen verwendet werden, welche jedes der Module 20, 23, 30, 40 eindeutig identifizieren, beispielsweise aufgrund einer MAC-Adresse.

Die von den Steuerungsmodulen 20, 23 und dem Platzhaltermodul 40 veränderten Kommunikationsdaten können anschließend an den Steuerungsrechner 9 zurückübermittelt werden. Der Steuerungsrechner 9 kann aus den Kommunikationsdaten beispielsweise eine Anzahl der durch Platzhaltermodule belegten Modulanschlüsse feststellen. Bei einer Neukonfiguration des siebten industriellen Steuerungssystems 7 kann höchstens eine dieser Anzahl entsprechende Zahl von zusätzlichen Steuerungsmodulen in das siebte Steuerungssystem 7 eingebaut werden.

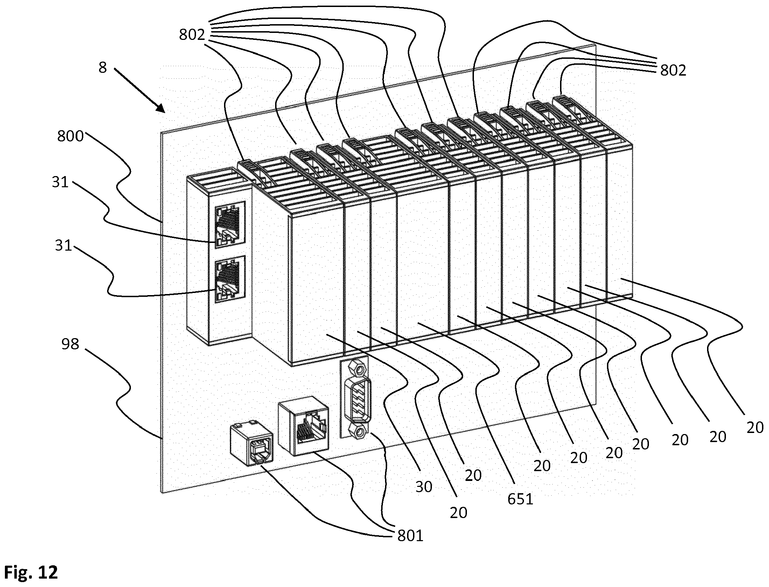

**Figur 12** zeigt eine Gesamtansicht eines achten industriellen Steuerungssystems 8 mit einer achten Koppeleinheit 800 und einer achten Busplatine 98. Soweit nicht abweichend beschrieben, sind das achte industrielle Steuerungssystem 8, die achte Koppeleinheit 800 und die achte Busplatine 98 ausgebildet wie das erste industrielle Steuerungssystem 1, die erste Koppeleinheit 100 und die erste Busplatine 91.

An der achten Koppeleinheit 800 sind neun der im Zusammenhang mit dem ersten industriellen Steuerungssystem 1 beschriebenen ersten Steuerungsmodule 20 und das im Zusammenhang mit dem sechsten industriellen Steuerungssystem 6 beschriebene breite Steuerungsmodul 651 angeordnet. Weiterhin umfasst das achte industrielle Steuerungssystem 8 das erste Umsetzermodul 30 mit der Schnittstelle 31, über welche eine Verbindung zu dem übergeordneten Datenpfad 50 hergestellt werden kann. Die Schnittstelle 31 kann beispielsweise zwei als RJ-45-Buchsen ausgebildete Netzwerkanschlüsse umfassen.

Die Steuerungsmodule 20, 651 und das erste Umsetzermodul 30 sind aneinander angrenzend und in einer Reihe an der Busplatine 98 angeordnet. Dabei ist das Umsetzermodul 30 an einem Ende der Reihe platziert. Die Steuerungsmodule 20, 651 und das erste Umsetzermodul 30 sind über mechanische Verriegelungselemente 802, welche in Form von Rastnasen ausgebildet sind, mechanisch mit der achten Busplatine 98 verbunden. Die Rastnasen sind jeweils an zwei entlang der Reihe und senkrecht zu der achten Busplatine 98 orientierten Seitenflächen der Module 20, 651, 30 angeordnet und greifen in Aussparungen der achten Busplatine 98 verankernd ein. Die Verankerung kann durch Druck auf die Rastnasen und eine durch den Druck verursachte Verbiegung der Rastnasen gelöst werden.

Außerdem sind an der achten Busplatine 98 drei zusätzliche elektrische Verbindungselemente 801 angeordnet. Die elektrischen Verbindungselemente 801 ermöglichen eine Datenverbindung zwischen einem externen Konfigurationsrechner und der achten Busplatine 98. Die elektrischen Verbindungselemente 801 sind als USB-Buchse, als Netzwerkbuchse und als serielle D-Sub Buchse ausgeführt, können aber auch einen anderen, für eine Datenverbindung geeigneten Formfaktor aufweisen. Über den an die Verbindungselemente 801 anschließbaren Konfigurationsrechner können beispielsweise Bauteile, die zusätzlich zu den Modulen 20, 651, 30 auf der achten Busplatine 98 angeordnet sind, etwa Spannungswandler, konfiguriert werden.

## Patentansprüche

1. Koppeleinheit (100, 200, 300, 400, 500, 600, 700, 800) für ein industrielles Steuerungssystem (1, 2, 3, 4, 5, 6, 7, 8) mit
einem ersten Modulanschluss (120, 320, 680, 681, 682, 683, 684, 685) und einem zweiten Modulanschluss (130, 320, 680, 681, 682, 683, 684, 685) zur elektrischen Kontaktierung eines ersten bzw. eines zweiten Steuerungsmoduls (20, 22, 350, 651, 652, 653),
einem ersten Feldanschluss (150, 360) und einem zweiten Feldanschluss (155, 360) zur elektrischen Kontaktierung eines ersten bzw. eines zweiten industriellen Feldgeräts (10, 12),
einem Datenübertragungsmedium (160) zur Übertragung von Kommunikationsdaten und
einem Signalübertragungsmedium (170) mit einzelnen Signalleitungen (171) zur Übertragung von Feldsignalen,
wobei der erste Modulanschluss (120, 320, 680, 681, 682, 683, 684, 685) und der zweite Modulanschluss (130, 320, 680, 681, 682, 683, 684, 685) elektrische Kontaktelemente (110) umfassen, die einen Kommunikationssignalbereich (122) und einen Feldsignalbereich (123) ausbilden,
wobei Kontaktelemente (110) des Kommunikationssignalbereichs (122) des ersten und zweiten Modulanschlusses (120, 320, 680, 681, 682, 683, 684, 685) elektrisch leitend mit dem Datenübertragungsmedium (160) verbunden sind,
**dadurch gekennzeichnet, dass**
der erste Modulanschluss (120, 320, 680, 681, 682, 683, 684, 685), der zweite Modulanschluss (130, 320, 680, 681, 682, 683, 684, 685), der erste Feldanschluss (150, 360), der zweite Feldanschluss (155, 360), das Datenübertragungsmedium (160) und das Signalübertragungsmedium (170) von einer Busplatine (91, 92, 93, 94, 95, 96, 97, 98) umfasst werden,
das Signalübertragungsmedium (170) den ersten und den zweiten Modulanschluss (120, 130, 320, 680, 681, 682, 683, 684, 685) jeweils mit dem ersten und dem zweiten Feldanschluss (150, 155, 360) elektrisch leitend verbindet, und
dazu ausgebildet ist, eine Signalrangierung zwischen den Modulanschlüssen (120, 130, 320, 680, 681, 682, 683, 684, 685) und den Feldanschlüssen (150, 155, 360) auszuführen und die einzelnen Signalleitungen (171) des Signalübertragungsmediums (170) zu feldgerätespezifischen Signalleitungssträngen zusammenzufassen,
so dass das erste Feldgerät (10) über ein erstes gebündeltes Feldsignalübertragungsmedium (15) an den ersten Feldanschluss (150, 360) und das zweite Feldgerät (12) über ein zweites gebündeltes Feldsignalübertragungsmedium (15) an den zweiten Feldanschluss (155, 360) anschließbar ist.

2. Koppeleinheit (100, 200, 300, 400, 500, 600, 700, 800) gemäß Anspruch 1,
wobei zur Signalrangierung ein erstes Kontaktelement (110) des Feldsignalbereichs (123) des ersten Modulanschlusses (120, 320, 680, 681, 682, 683, 684, 685) über eine erste Signalleitung (171) und ein zweites Kontaktelement (110) des Feldsignalbereichs (123) des zweiten Modulanschlusses (130, 320, 680, 681, 682, 683, 684, 685) über eine zweite Signalleitung (171) mit dem ersten Feldanschluss (150, 360) und
ein drittes Kontaktelement (110) des Feldsignalbereichs (123) des ersten Modulanschlusses (120, 320, 680, 681, 682, 683, 684, 685) über eine dritte Signalleitung (171) und ein viertes Kontaktelement (110) des Feldsignalbereichs (123) des zweiten Modulanschlusses (130, 320, 680, 681, 682, 683, 684, 685) über eine vierte Signalleitung (171) mit dem zweiten Feldanschluss (155, 360) elektrisch leitend verbunden sind.

3. Koppeleinheit (100, 200, 300, 400, 500, 600, 700, 800) gemäß einem der vorigen Ansprüche,
wobei der erste Feldanschluss (150, 360) und/oder der zweite Feldanschluss (155, 360) als ein Stecker oder eine Buchse einer elektrischen Steckverbindung ausgeführt sind.

4. Koppeleinheit (100, 200, 300, 400, 500, 600, 700, 800) gemäß einem der vorigen Ansprüche,
wobei der erste und der zweite Modulanschluss (120, 130, 140, 145, 320, 680, 681, 682, 683, 684, 685) jeweils als ein Stecker oder eine Buchse einer elektrischen Steckverbindung ausgebildet sind und
der Kommunikationssignalbereich (122) und der Feldsignalbereich (123) des ersten und des zweiten Modulanschlusses (120, 130, 140, 145, 320, 680, 681, 682, 683, 684, 685) jeweils aus nebeneinanderliegenden Kontaktelementen (110) der elektrischen Steckverbindung bestehen.

5. Koppeleinheit (100, 200, 300, 400, 500, 600, 700, 800) gemäß einem der vorigen Ansprüche,
wobei die Koppeleinheit (100, 200, 300, 400, 500, 600, 700, 800) wenigstens zwei Modulanschlüsse (120, 130, 140, 145, 320, 680, 681, 682, 683, 684, 685) umfasst,
wobei der Kommunikationssignalbereich (122) der wenigstens zwei Modulanschlüsse (120, 130, 140, 145, 320, 420, 520, 620) jeweils zumindest ein Empfangskontaktelement (117, 118) und zumindest ein Sendekontaktelement (115, 116) umfasst und
wobei das zumindest eine Sendekontaktelement (115, 116) eines Ersten der wenigstens zwei Modulanschlüsse (120, 130, 140, 145, 320, 680, 681, 682, 683, 684, 685) über das Datenübertragungsmedium (160) mit dem zumindest einen Empfangskontaktelement (117, 118) eines Zweiten der wenigstens zwei Modulanschlüsse (120, 130, 140, 145, 320, 680, 681, 682, 683, 684, 685) elektrisch leitend verbunden ist und das zumindest eine Sendekontaktelement (115,116) des Zweiten der wenigstens zwei Modulanschlüsse (120, 130, 140, 145, 320, 680, 681, 682, 683, 684, 685) über das Datenübertragungsmedium (160) mit dem zumindest einen Empfangskontaktelement (117, 118) des Ersten der wenigstens zwei Modulanschlüsse (120, 130, 140, 145, 320, 680, 681, 682, 683, 684, 685) elektrisch leitend verbunden ist.

6. Koppeleinheit (100, 200, 300, 400, 500, 600, 700, 800) gemäß einem der vorigen Ansprüche,
wobei das Datenübertragungsmedium (160) zumindest einen ersten Datenkanal (161) und zumindest einen zweiten Datenkanal (162) umfasst und
wobei eine erste Anzahl (165) von Kontaktelementen (110) des Kommunikationssignalbereichs (122) des ersten und des zweiten Modulanschlusses (120, 130, 140, 145, 320, 680, 681, 682, 683, 684, 685) mit dem zumindest einen ersten Datenkanal (161) elektrisch leitend verbunden ist und eine zweite Anzahl (166) von Kontaktelementen (110) des Kommunikationssignalbereichs (122) des ersten und des zweiten Modulanschlusses (120, 130, 140, 145, 320, 680, 681, 682, 683, 684, 685) mit dem zumindest einen zweiten Datenkanal (162) elektrisch leitend verbunden ist.

7. Koppeleinheit (100, 200, 300, 400, 500, 600, 700, 800) gemäß einem der vorigen Ansprüche,
wobei das Datenübertragungsmedium (160) im Kommunikationssignalbereich (122) des ersten und des zweiten Modulanschlusses (120, 130, 140, 145, 320, 680, 681, 682, 683, 684, 685) unterbrochen ist.

8. Koppeleinheit (100, 200, 300, 400, 500, 600, 700, 800) gemäß einem der vorigen Ansprüche,
wobei wenigstens einer des ersten und des zweiten Modulanschlusses (120, 130, 140, 145, 320, 680, 681, 682, 683, 684, 685) elektrische Kontaktelemente (110) aufweist, die einen Spannungsversorgungsbereich (124) ausbilden und mit einer Feldspannungsversorgung (101) der Koppeleinheit (100, 200, 300, 400, 500, 600, 700, 800) elektrisch leitend verbunden sind, und
wobei die Kontaktelemente (110) des Feldsignalbereichs (123) zwischen den Kontaktelementen (110) des Kommunikationssignalbereichs (122) und den Kontaktelementen (110) des Spannungsversorgungsbereichs (124) angeordnet sind.

9. Koppeleinheit (100, 200, 300, 400, 500, 600, 700, 800) gemäß einem der vorigen Ansprüche
mit weiteren Modulanschlüssen (120, 130, 140, 145, 320, 680, 681, 682, 683, 684, 685),
wobei die Modulanschlüsse (120, 130, 140, 145, 320, 680, 681, 682, 683, 684, 685) eine im Wesentlichen rechteckige Form mit einer langen Seite (525) und einer kurzen Seite (526) aufweisen,
wobei die langen Seiten (525) der Modulanschlüsse (120, 130, 140, 145, 320, 680, 681, 682, 683, 684, 685) im Wesentlichen parallel zueinander angeordnet sind,
wobei eine erste Anzahl (521) von Modulanschlüssen (120, 130, 140, 145, 320, 680, 681, 682, 683, 684, 685) in einer ersten Reihe (580) voneinander beabstandet angeordnet ist, wobei die Kontaktelemente (110) der Kommunikationssignalbereiche (122) der ersten Anzahl (521) von Modulanschlüssen (120, 130, 140, 145, 320, 680, 681, 682, 683, 684, 685) der ersten Reihe (580) nach miteinander über das Datenübertragungsmedium (160) elektrisch leitend verbunden sind,
wobei eine zweite Anzahl (522) von Modulanschlüssen (120, 130, 140, 145, 320, 680, 681, 682, 683, 684, 685) in einer zweiten Reihe (582) voneinander beabstandet angeordnet ist, wobei die Kontaktelemente (110) der Kommunikationssignalbereiche (122) der zweiten Anzahl (522) von Modulanschlüssen (120, 130, 140, 145, 320, 680, 681, 682, 683, 684, 685) der zweiten Reihe (582) nach miteinander über das Datenübertragungsmedium (160) elektrisch leitend verbunden sind,
wobei die zweite Reihe (582) unter der ersten Reihe (580) und parallel zu der ersten Reihe (580) angeordnet ist, wobei die Kontaktelemente (110) des Kommunikationssignalbereichs (122) eines letzten kontaktierten Modulanschlusses (581) der ersten Reihe (580) über das Datenübertragungsmedium (160) mit den Kontaktelementen (110) des Kommunikationssignalbereichs (122) eines ersten kontaktierten Modulanschlusses (583) der zweiten Reihe (582) elektrisch leitend verbunden sind.

10. Koppeleinheit (100, 200, 300, 400, 500, 600, 700, 800) gemäß Anspruch 9,
wobei eine dritte Anzahl (523) von Modulanschlüssen (120, 130, 140, 145, 320, 680, 681, 682, 683, 684, 685) in einer dritten Reihe (585) voneinander beabstandet angeordnet ist, wobei die dritte Reihe (585) parallel zu der ersten Reihe (580) und an die erste Reihe (580) anschließend angeordnet ist,
wobei die Kontaktelemente (110) der Kommunikationssignalbereiche (122) der dritten Anzahl (523) der Modulanschlüsse (120, 130, 140, 145, 320, 680, 681, 682, 683, 684, 685) der dritten Reihe (585) nach miteinander über das Datenübertragungsmedium (160) elektrisch leitend verbunden sind,
wobei die Kontaktelemente (110) des Kommunikationssignalbereichs (122) eines letzten kontaktierten Modulanschlusses (584) der zweiten Reihe (582) über das Datenübertragungsmedium (160) mit den Kontaktelementen (110) des Kommunikationssignalbereichs (122) eines ersten kontaktierten Modulanschlusses (586) der dritten Reihe (587) elektrisch leitend verbunden sind.

11. Koppeleinheit (100, 200, 300, 400, 500, 600, 700, 800) gemäß einem der vorigen Ansprüche,
wobei die Busplatine (91, 92, 93, 94, 95, 96, 97, 98) zumindest eine Modulanschlussplatine (301, 401) mit dem ersten und zweiten Modulanschluss(120, 130, 140, 145, 320, 680, 681, 682, 683, 684, 685) und zumindest eine Feldanschlussplatine (302, 402) mit dem ersten und zweiten Feldanschluss (150, 360) umfasst,
wobei die zumindest eine Modulanschlussplatine (301, 401) und die zumindest eine Feldanschlussplatine (302, 402) über ein erstes Verbindungselement (330, 430, 530) und ein zweites Verbindungselement (340, 440, 540) elektrisch leitend miteinander verbunden sind,
wobei die Kontaktelemente (110) der Feldsignalbereiche (122) einer ersten Gruppe (321, 421, 422) von Modulanschlüssen (120, 130, 140, 145, 320, 680, 681, 682, 683, 684, 685) mit dem ersten Verbindungselement (330, 430, 530) elektrisch leitend verbunden sind und
wobei die Kontaktelemente (110) der Feldsignalbereiche (122) einer zweiten Gruppe (322, 423, 424) von Modulanschlüssen (120, 130, 140, 145, 320, 680, 681, 682, 683, 684, 685) mit dem zweiten Verbindungselement (340, 440, 540) elektrisch leitend verbunden sind.

12. Industrielles Steuerungssystem (1, 2, 3, 4, 5, 6, 7, 8) mit einer Koppeleinheit (100, 200, 300, 400, 500, 600, 700, 800) gemäß einem der Ansprüche 1 bis 11,
einem ersten Steuerungsmodul (20, 22, 23, 350, 651, 652, 653), welches an den ersten Modulanschluss (120, 320, 680, 681, 682, 683, 684, 685) der Koppeleinheit (100, 200, 300, 400, 500, 600, 700, 800) angeschlossen ist,
einem zweiten Steuerungsmodul (22, 23, 350, 651, 652, 653), welches an den zweiten Modulanschluss (130, 320, 680, 681, 682, 683, 684, 685) der Koppeleinheit (100, 200, 300, 400, 500, 600, 700, 800) angeschlossen ist,
einem ersten Feldgerät (10), welches über ein gebündeltes erstes Feldsignalübertragungsmedium (15) an den ersten Feldanschluss (150, 360) angeschlossen ist, und
einem zweiten Feldgerät (12), welches über ein gebündeltes zweites Feldsignalübertragungsmedium (15) an den zweiten Feldanschluss (155, 360) angeschlossen ist,
wobei das industrielle Steuerungssystem (1, 2, 3, 4, 5, 6, 7, 8) dazu ausgebildet ist, Feldsignale des ersten und zweiten Steuerungsmoduls (20, 22, 23, 350, 651, 652, 653) über das Signalübertragungsmedium (170), den ersten Feldanschluss (150, 360) und das erste Feldsignalübertragungsmedium (15) an das erste Feldgerät (10) und
Feldsignale des ersten und zweiten Steuerungsmoduls (20, 22, 23, 350, 651, 652, 653) über das Signalübertragungsmedium (170), den zweiten Feldanschluss (155, 360) und das zweite Feldsignalübertragungsmedium (15) an das zweite Feldgerät (12) zu übertragen.

13. Industrielles Steuerungssystem (1, 2, 3, 4, 5, 6, 7, 8) gemäß Anspruch 12,
bei dem die Koppeleinheit (100, 200, 300, 400, 500, 600, 700, 800) einen Umsetzermodulanschluss (146, 246) aufweist, mit einem Umsetzermodul (30, 32) mit einer Schnittstelle (31, 33) zu einem übergeordneten Datenpfad (50),
wobei das Umsetzermodul (30, 32) dazu ausgebildet ist, Kontaktelemente (110) des Umsetzermodulanschlusses (146, 246) elektrisch leitend zu kontaktieren,
wobei das Umsetzermodul (30, 32) dazu ausgebildet ist, Kommunikationsdaten zwischen der Schnittstelle (31, 33) zu dem übergeordneten Datenpfad (50) und Kontaktelementen (110) eines Kommunikationssignalbereichs (122) des Umsetzermodulanschlusses (146, 246) zu übertragen.

14. Industrielles Steuerungssystem (1, 2, 3, 4, 5, 6, 7, 8) gemäß Anspruch 13,
wobei ein Teil des übergeordneten Datenpfads (50) auf der Koppeleinheit (100, 200, 300, 400, 500, 600, 700, 800) angeordnet ist,
wobei der übergeordnete Datenpfad (50) Kontaktelemente (110) des Umsetzermodulanschlusses (146, 246) elektrisch leitend kontaktiert.

15. Industrielles Steuerungssystem (1, 2, 3, 4, 5, 6, 7, 8) gemäß einem der Ansprüche 12 bis 14,
wobei das Umsetzermodul (30, 32), das erste und zweite Steuerungsmodul (20, 22, 23, 350, 651, 652, 653) und das Datenübertragungsmedium (160) dazu ausgebildet sind, die Kommunikationsdaten mittels E-Bus-Datentelegrammen zu übermitteln, und
wobei das Umsetzermodul (30, 32) dazu ausgebildet ist, die Kommunikationsdaten mittels Ethernet-Datentelegrammen, insbesondere mittels EtherCAT-Datentelegrammen, über den übergeordneten Datenpfad (50) zu übertragen.

## Claims

1. Coupling unit (100, 200, 300, 400, 500, 600, 700, 800) for an industrial control system (1, 2, 3, 4, 5, 6, 7, 8), having
a first module connection (120, 320, 680, 681, 682, 683, 684, 685) and a second module connection (130, 320, 680, 681, 682, 683, 684, 685) for making electrical contact with a first and a second control module (20, 22, 350, 651, 652, 653),
a first field connection (150, 360) and a second field connection (155, 360) for making electrical contact with a first and a second industrial field device (10, 12),
a data transmission medium (160) for transmitting communication data, and
a signal transmission medium (170) having individual signal lines (171) for transmitting field signals,
the first module connection (120, 320, 680, 681, 682, 683, 684, 685) and the second module connection (130, 320, 680, 681, 682, 683, 684, 685) comprising electrical contact elements (110) which form a communication signal region (122) and a field signal region (123),
contact elements (110) of the communication signal region (122) of the first and second module connections (120, 320, 680, 681, 682, 683, 684, 685) being connected to the data transmission medium (160) in an electrically conductive manner, **characterized in that**
the first module connection (120, 320, 680, 681, 682, 683, 684, 685), the second module connection (130, 320, 680, 681, 682, 683, 684, 685), the first field connection (150, 360), the second field connection (155, 360), the data transmission medium (160) and the signal transmission medium (170) are included in a bus board (91, 92, 93, 94, 95, 96, 97, 98),
the signal transmission medium (170) respectively connects the first and second module connections (120, 130, 320, 680, 681, 682, 683, 684, 685) to the first and second field connections (150, 155, 360) in an electrically conductive manner and is designed to carry out signal routing between the module connections (120, 130, 320, 680, 681, 682, 683, 684, 685) and the field connections (150, 155, 360) and to combine the individual signal lines (171) of the signal transmission medium (170) to form field-device-specific signal line bundles,
with the result that the first field device (10) can be connected to the first field connection (150, 360) via a first bundled field signal transmission medium (15) and the second field device (12) can be connected to the second field connection (155, 360) via a second bundled field signal transmission medium (15).

2. Coupling unit (100, 200, 300, 400, 500, 600, 700, 800) according to Claim 1,
in which case, for signal routing, a first contact element (110) of the field signal region (123) of the first module connection (120, 320, 680, 681, 682, 683, 684, 685) is connected to the first field connection (150, 360) in an electrically conductive manner via a first signal line (171) and a second contact element (110) of the field signal region (123) of the second module connection (130, 320, 680, 681, 682, 683, 684, 685) is connected to the first field connection (150, 360) in an electrically conductive manner via a second signal line (171), and
a third contact element (110) of the field signal region (123) of the first module connection (120, 320, 680, 681, 682, 683, 684, 685) is connected to the second field connection (155, 360) in an electrically conductive manner via a third signal line (171) and a fourth contact element (110) of the field signal region (123) of the second module connection (130, 320, 680, 681, 682, 683, 684, 685) is connected to the second field connection (155, 360) in an electrically conductive manner via a fourth signal line (171).

3. Coupling unit (100, 200, 300, 400, 500, 600, 700, 800) according to one of the preceding claims,
the first field connection (150, 360) and/or the second field connection (155, 360) being in the form of a male connector or a female connector of an electrical plug-in connection.

4. Coupling unit (100, 200, 300, 400, 500, 600, 700, 800) according to one of the preceding claims,
the first and second module connections (120, 130, 140, 145, 320, 680, 681, 682, 683, 684, 685) each being in the form of a male connector or a female connector of an electrical plug-in connection, and the communication signal region (122) and the field signal region (123) of the first and second module connections (120, 130, 140, 145, 320, 680, 681, 682, 683, 684, 685) each consisting of contact elements (110) of the electrical plug-in connection which are beside one another.

5. Coupling unit (100, 200, 300, 400, 500, 600, 700, 800) according to one of the preceding claims,
the coupling unit (100, 200, 300, 400, 500, 600, 700, 800) comprising at least two module connections (120, 130, 140, 145, 320, 680, 681, 682, 683, 684, 685),
the communication signal region (122) of the at least two module connections (120, 130, 140, 145, 320, 420, 520, 620) respectively comprising at least one receiving contact element (117, 118) and at least one transmitting contact element (115, 116), and
the at least one transmitting contact element (115, 116) of a first of the at least two module connections (120, 130, 140, 145, 320, 680, 681, 682, 683, 684, 685) being connected to the at least one receiving contact element (117, 118) of a second of the at least two module connections (120, 130, 140, 145, 320, 680, 681, 682, 683, 684, 685) in an electrically conductive manner via the data transmission medium (160), and the at least one transmitting contact element (115, 116) of the second of the at least two module connections (120, 130, 140, 145, 320, 680, 681, 682, 683, 684, 685) being connected to the at least one receiving contact element (117, 118) of the first of the at least two module connections (120, 130, 140, 145, 320, 680, 681, 682, 683, 684, 685) in an electrically conductive manner via the data transmission medium (160).

6. Coupling unit (100, 200, 300, 400, 500, 600, 700, 800) according to one of the preceding claims,
the data transmission medium (160) comprising at least one first data channel (161) and at least one second data channel (162), and
a first number (165) of contact elements (110) of the communication signal region (122) of the first and second module connections (120, 130, 140, 145, 320, 680, 681, 682, 683, 684, 685) being connected to the at least one first data channel (161) in an electrically conductive manner, and a second number (166) of contact elements (110) of the communication signal region (122) of the first and second module connections (120, 130, 140, 145, 320, 680, 681, 682, 683, 684, 685) being connected to the at least one second data channel (162) in an electrically conductive manner.

7. Coupling unit (100, 200, 300, 400, 500, 600, 700, 800) according to one of the preceding claims,
the data transmission medium (160) being interrupted in the communication signal region (122) of the first and second module connections (120, 130, 140, 145, 320, 680, 681, 682, 683, 684, 685).

8. Coupling unit (100, 200, 300, 400, 500, 600, 700, 800) according to one of the preceding claims,
at least one of the first and second module connections (120, 130, 140, 145, 320, 680, 681, 682, 683, 684, 685) having electrical contact elements (110) which form a voltage supply region (124) and are connected to a field voltage supply (101) of the coupling unit (100, 200, 300, 400, 500, 600, 700, 800) in an electrically conductive manner, and
the contact elements (110) of the field signal region (123) being arranged between the contact elements (110) of the communication signal region (122) and the contact elements (110) of the voltage supply region (124).

9. Coupling unit (100, 200, 300, 400, 500, 600, 700, 800) according to one of the preceding claims, having further module connections (120, 130, 140, 145, 320, 680, 681, 682, 683, 684, 685),
the module connections (120, 130, 140, 145, 320, 680, 681, 682, 683, 684, 685) having a substantially rectangular form with a long side (525) and a short side (526),
the long sides (525) of the module connections (120, 130, 140, 145, 320, 680, 681, 682, 683, 684, 685) being arranged substantially parallel to one another,
a first number (521) of module connections (120, 130, 140, 145, 320, 680, 681, 682, 683, 684, 685) being arranged at a distance from one another in a first row (580),
the contact elements (110) of the communication signal regions (122) of the first number (521) of module connections (120, 130, 140, 145, 320, 680, 681, 682, 683, 684, 685) being sequentially connected to one another along the first row (580) in an electrically conductive manner via the data transmission medium (160),
a second number (522) of module connections (120, 130, 140, 145, 320, 680, 681, 682, 683, 684, 685) being arranged at a distance from one another in a second row (582),
the contact elements (110) of the communication signal regions (122) of the second number (522) of module connections (120, 130, 140, 145, 320, 680, 681, 682, 683, 684, 685) being sequentially connected to one another along the second row (582) in an electrically conductive manner via the data transmission medium (160),
the second row (582) being arranged below the first row (580) and parallel to the first row (580),
the contact elements (110) of the communication signal region (122) of a last module connection (581) with which contact has been made in the first row (580) being connected to the contact elements (110) of the communication signal region (122) of a first module connection (583) with which contact has been made in the second row (582) in an electrically conductive manner via the data transmission medium (160).

10. Coupling unit (100, 200, 300, 400, 500, 600, 700, 800) according to Claim 9,
a third number (523) of module connections (120, 130, 140, 145, 320, 680, 681, 682, 683, 684, 685) being arranged at a distance from one another in a third row (585),
the third row (585) being arranged parallel to the first row (580) and in a manner adjoining the first row (580),
the contact elements (110) of the communication signal regions (122) of the third number (523) of module connections (120, 130, 140, 145, 320, 680, 681, 682, 683, 684, 685) being sequentially connected to one another along the third row (585) in an electrically conductive manner via the data transmission medium (160),
the contact elements (110) of the communication signal region (122) of a last module connection (584) with which contact has been made in the second row (582) being connected to the contact elements (110) of the communication signal region (122) of a first module connection (586) with which contact has been made in the third row (587) in an electrically conductive manner via the data transmission medium (160).

11. Coupling unit (100, 200, 300, 400, 500, 600, 700, 800) according to one of the preceding claims,
the bus board (91, 92, 93, 94, 95, 96, 97, 98) comprising at least one module connection board (301, 401) with the first and second module connections (120, 130, 140, 145, 320, 680, 681, 682, 683, 684, 685) and at least one field connection board (302, 402) with the first and second field connections (150, 360),
the at least one module connection board (301, 401) and the at least one field connection board (302, 402) being connected to one another in an electrically conductive manner via a first connecting element (330, 430, 530) and a second connecting element (340, 440, 540),
the contact elements (110) of the field signal regions (122) of a first group (321, 421, 422) of module connections (120, 130, 140, 145, 320, 680, 681, 682, 683, 684, 685) being connected to the first connecting element (330, 430, 530) in an electrically conductive manner, and
the contact elements (110) of the field signal regions (122) of a second group (322, 423, 424) of module connections (120, 130, 140, 145, 320, 680, 681, 682, 683, 684, 685) being connected to the second connecting element (340, 440, 540) in an electrically conductive manner.

12. Industrial control system (1, 2, 3, 4, 5, 6, 7, 8) having a coupling unit (100, 200, 300, 400, 500, 600, 700, 800) according to one of Claims 1 to 11, a first control module (20, 22, 23, 350, 651, 652, 653) which is connected to the first module connection (120, 320, 680, 681, 682, 683, 684, 685) of the coupling unit (100, 200, 300, 400, 500, 600, 700, 800),
a second control module (22, 23, 350, 651, 652, 653) which is connected to the second module connection (130, 320, 680, 681, 682, 683, 684, 685) of the coupling unit (100, 200, 300, 400, 500, 600, 700, 800),
a first field device (10) which is connected to the first field connection (150, 360) via a bundled first field signal transmission medium (15), and
a second field device (12) which is connected to the second field connection (155, 360) via a bundled second field signal transmission medium (15),
the industrial control system (1, 2, 3, 4, 5, 6, 7, 8) being designed to transmit field signals from the first and second control modules (20, 22, 23, 350, 651, 652, 653) to the first field device (10) via the signal transmission medium (170), the first field connection (150, 360) and the first field signal transmission medium (15) and
to transmit field signals from the first and second control modules (20, 22, 23, 350, 651, 652, 653) to the second field device (12) via the signal transmission medium (170), the second field connection (155, 360) and the second field signal transmission medium (15).

13. Industrial control system (1, 2, 3, 4, 5, 6, 7, 8) according to Claim 12,
in which the coupling unit (100, 200, 300, 400, 500, 600, 700, 800) has a converter module connection (146, 246), having a converter module (30, 32) with an interface (31, 33) to a superordinate data path (50),
the converter module (30, 32) being designed to make contact with contact elements (110) of the converter module connection (146, 246) in an electrically conductive manner,
the converter module (30, 32) being designed to transmit communication data between the interface (31, 33) to the superordinate data path (50) and contact elements (110) of a communication signal region (122) of the converter module connection (146, 246).

14. Industrial control system (1, 2, 3, 4, 5, 6, 7, 8) according to Claim 13,
one part of the superordinate data path (50) being arranged on the coupling unit (100, 200, 300, 400, 500, 600, 700, 800),
the superordinate data path (50) making contact with contact elements (110) of the converter module connection (146, 246) in an electrically conductive manner.

15. Industrial control system (1, 2, 3, 4, 5, 6, 7, 8) according to one of Claims 12 to 14,
the converter module (30, 32), the first and second control modules (20, 22, 23, 350, 651, 652, 653) and the data transmission medium (160) being designed to transmit the communication data by means of E-bus data messages, and
the converter module (30, 32) being designed to transmit the communication data by means of Ethernet data messages, in particular by means of EtherCAT data messages, via the superordinate data path (50).

## Revendications

1. Unité de couplage (100, 200, 300, 400, 500, 600, 700, 800) pour système industriel de commande (1, 2, 3, 4, 5, 6, 7, 8), présentant
un premier raccordement de module (120, 320, 680, 681, 682, 683, 684, 685) et un deuxième raccordement de module (130, 320, 680, 681, 682, 683, 684, 685) qui assurent la mise en contact électrique respectivement d'un premier et d'un deuxième module de commande (20, 22, 350, 651, 652, 653),
un premier raccordement de terrain (150, 360) et un deuxième raccordement de terrain (155, 360) qui assurent la mise en contact électrique respectivement d'un premier et d'un deuxième appareil industriel de terrain (10, 12),
un support (160) de transfert de données qui transfère des données de communication et
un support (170) de transfert de signaux qui présente différents conducteurs (171) de signaux qui transfèrent des signaux de terrain,
le premier raccordement de module (120, 320, 680, 681, 682, 683, 684, 685) et le deuxième raccordement de module (130, 320, 680, 681, 682, 683, 684, 685) comprenant des éléments (110) de mise en contact électrique qui forment une partie (122) de signaux de communication et une partie (123) de signaux de terrain,
des éléments (110) de mise en contact de la partie (122) de signaux de communication du premier et du deuxième raccordement de module (120, 320, 680, 681, 682, 683, 684, 685) étant raccordés de manière électriquement conductrice au support (160) de transfert de données,
**caractérisée en ce que**
le premier raccordement de module (120, 320, 680, 681, 682, 683, 684, 685), le deuxième raccordement de module (130, 320, 680, 681, 682, 683, 684, 685), le premier raccordement de terrain (150, 360), le deuxième raccordement de terrain (155, 360), le support (160) de transfert de données et le support (170) de transfert de signaux sont incorporés dans une carte de bus (91, 92, 93, 94, 95, 96, 97, 98),
**en ce que** le support (170) de transfert de signaux relie de manière électriquement conductrice le premier et le deuxième raccordement de module (120, 130, 320, 680, 681, 682, 683, 684, 685) respectivement au premier et au deuxième raccordement de terrain (150, 155, 360) et est configuré pour exécuter un rangement de signaux entre les raccordements de module (120, 130, 320, 680, 681, 682, 683, 684, 685) et les raccordements de terrain (150, 155, 360) et pour rassembler les différents conducteurs (171) de signaux du support (170) de transfert de signaux en faisceau de conducteurs de signaux spécifiques aux appareils de terrain de telle sorte que le premier appareil de terrain (10) puisse être raccordé par l'intermédiaire d'un premier support (15) de transfert de signaux de terrain rassemblé en faisceau au premier raccordement de terrain (150, 360) et que le deuxième appareil de terrain (12) puisse être raccordé par l'intermédiaire d'un deuxième support (15) de transfert de signaux de terrain rassemblé en faisceau au deuxième raccordement de terrain (155, 360).

2. Unité de couplage (100, 200, 300, 400, 500, 600, 700, 800) selon la revendication 1, dans laquelle, pour le rangement des signaux, un premier élément (110) de mise en contact de la partie (123) de signaux de terrain du premier raccordement de module (120, 320, 680, 681, 682, 683, 684, 685) est raccordé de manière électriquement conductrice au premier raccordement de terrain (150, 360) par l'intermédiaire d'un premier conducteur (171) de signaux et un deuxième élément (110) de mise en contact de la partie (123) de signaux de terrain du deuxième raccordement de module (130, 320, 680, 681, 682, 683, 684, 685) est raccordé de manière électriquement conductrice par l'intermédiaire d'un deuxième conducteur (171) de signaux au premier raccordement de terrain (150, 360), un troisième élément (110) de mise en contact de la partie (123) de signaux de terrain du premier raccordement de module (120, 320, 680, 681, 682, 683, 684, 685) étant raccordé de manière électriquement conductrice par l'intermédiaire d'un troisième conducteur (171) de signaux au deuxième raccordement de terrain (155, 360) et un quatrième élément (110) de mise en contact de la partie (123) de signaux de terrain du deuxième raccordement de module (130, 320, 680, 681, 682, 683, 684, 685) étant raccordé de manière électriquement conductrice par l'intermédiaire d'un quatrième conducteur (171) de signaux au deuxième raccordement de terrain (155, 360).

3. Unité de couplage (100, 200, 300, 400, 500, 600, 700, 800) selon l'une des revendications précédentes, dans laquelle le premier raccordement de terrain (150, 360) et/ou le deuxième raccordement de terrain (155, 360) sont configurés comme fiche ou douille d'un raccord électrique enfichable.

4. Unité de couplage (100, 200, 300, 400, 500, 600, 700, 800) selon l'une des revendications précédentes, dans laquelle le premier et le deuxième raccordement de module (120, 130, 140, 145, 320, 680, 681, 682, 683, 684, 685) sont tous deux configurés comme fiche ou douille d'un raccord électrique enfichable et la partie (122) de signaux de communication ainsi que la partie (123) de signaux de terrain du premier et du deuxième raccordement de module (120, 130, 140, 145, 320, 680, 681, 682, 683, 684, 685) sont toutes deux constituées d'éléments (110) de mise en contact, disposés les uns à côté des autres, du raccord électrique enfichable.

5. Unité de couplage (100, 200, 300, 400, 500, 600, 700, 800) selon l'une des revendications précédentes, dans laquelle l'unité de couplage (100, 200, 300, 400, 500, 600, 700, 800) comporte au moins deux raccordements de module (120, 130, 140, 145, 320, 680, 681, 682, 683, 684, 685), la partie (122) de signaux de communication des deux ou plusieurs raccordements de module (120, 130, 140, 145, 320, 420, 520, 620) comportant au moins un élément (117, 118) de contact de réception et au moins un élément (115, 116) de contact d'émission,
le ou les éléments (115, 116) de contact d'émission d'un premier des deux ou plusieurs raccordements de module (120, 130, 140, 145, 320, 680, 681, 682, 683, 684, 685) étant reliés de manière électriquement conductrice par l'intermédiaire du support (160) de transfert de données à l'élément ou aux éléments (117, 118) de contact de réception d'un deuxième des deux ou plusieurs raccordements de module (120, 130, 140, 145, 320, 680, 681, 682, 683, 684, 685) et le ou les éléments (115, 116) de contact d'émission du deuxième des deux ou plusieurs raccordements de module (120, 130, 140, 145, 320, 680, 681, 682, 683, 684, 685) étant reliés de manière électriquement conductrice par l'intermédiaire du support (160) de transfert de données à l'élément ou aux éléments (117, 118) de contact de réception du premier des deux ou plusieurs raccordements de module (120, 130, 140, 145, 320, 680, 681, 682, 683, 684, 685).

6. Unité de couplage (100, 200, 300, 400, 500, 600, 700, 800) selon l'une des revendications précédentes, dans laquelle le support (160) de transfert de données comporte au moins un premier canal de données (161) et au moins un deuxième canal de données (162),
un premier nombre (165) d'éléments (110) de mise en contact de la partie (122) de signaux de communication du premier et du deuxième raccordement de module (120, 130, 140, 145, 320, 680, 681, 682, 683, 684, 685) étant relié de manière électriquement conductrice au premier ou aux premiers canaux de données (161) et un deuxième nombre (166) d'éléments (110) de mise en contact de la partie (122) de signaux de communication du premier et du deuxième raccordement de module (120, 130, 140, 145, 320, 680, 681, 682, 683, 684, 685) étant relié de manière électriquement conductrice au deuxième ou aux deuxièmes canaux de données (162).

7. Unité de couplage (100, 200, 300, 400, 500, 600, 700, 800) selon l'une des revendications précédentes, dans laquelle le support (160) de transfert de données est interrompu dans la partie (122) de signaux de communication du premier et du deuxième raccordement de module (120, 130, 140, 145, 320, 680, 681, 682, 683, 684, 685).

8. Unité de couplage (100, 200, 300, 400, 500, 600, 700, 800) selon l'une des revendications précédentes, dans laquelle au moins l'un parmi le premier et le deuxième raccordement de module (120, 130, 140, 145, 320, 680, 681, 682, 683, 684, 685) présente des éléments (110) de mise en contact électrique qui forment une partie (124) d'alimentation en tension et qui sont reliés de manière électriquement conductrice à une alimentation (101) en tension de terrain de l'unité de couplage (100, 200, 300, 400, 500, 600, 700, 800), les éléments (110) de mise en contact de la partie (123) de signaux de terrain étant disposés entre les éléments (110) de mise en contact de la partie (122) de signaux de communication et les éléments (110) de mise en contact de la partie (124) d'alimentation en tension.

9. Unité de couplage (100, 200, 300, 400, 500, 600, 700, 800) selon l'une des revendications précédentes, présentant d'autres raccordements de module (120, 130, 140, 145, 320, 680, 681, 682, 683, 684, 685), les raccordements de module (120, 130, 140, 145, 320, 680, 681, 682, 683, 684, 685) présentant une forme essentiellement rectangulaire dotée d'un côté long (525) et d'un côté court (526),
les côtés longs (525) des raccordements de module (120, 130, 140, 145, 320, 680, 681, 682, 683, 684, 685) étant disposés essentiellement en parallèle l'un à l'autre,
un premier nombre (521) de raccordements de module (120, 130, 140, 145, 320, 680, 681, 682, 683, 684, 685) étant disposé à distance mutuelle en une première série (580),
les éléments (110) de mise en contact des parties (122) de signaux de communication du premier nombre (521) de raccordement de module (120, 130, 140, 145, 320, 680, 681, 682, 683, 684, 685) de la première série (580) étant raccordés de manière électriquement conductrice les uns aux autres par l'intermédiaire du support (160) de transfert de données,
un deuxième nombre (522) de raccordements de module (120, 130, 140, 145, 320, 680, 681, 682, 683, 684, 685) étant disposé à distance mutuelle en une deuxième série (582),
les éléments (110) de mise en contact des parties (122) de signaux de communication du deuxième nombre (522) de raccordement de module (120, 130, 140, 145, 320, 680, 681, 682, 683, 684, 685) de la deuxième série (582) étant raccordés de manière électriquement conductrice les uns aux autres par l'intermédiaire du support (160) de transfert de données,
la deuxième série (582) étant disposée en dessous de la première série (580) et parallèlement à la première série (580),
les éléments (110) de mise en contact de la partie (122) de signaux de communication d'un dernier raccordement de module (581) mis en contact dans la première série (580) étant raccordés de manière électriquement conductrice par l'intermédiaire du support (160) de transfert de données aux éléments (110) de mise en contact de la partie (122) de signaux de communication d'un premier raccordement de module (583) mis en contact dans la deuxième série (582).

10. Unité de couplage (100, 200, 300, 400, 500, 600, 700, 800) selon la revendication 9, dans laquelle un troisième nombre (523) de raccordements de module (120, 130, 140, 145, 320, 680, 681, 682, 683, 684, 685) est disposé à distance mutuelle en une troisième série (585), la troisième série (585) étant disposée parallèlement à la première série (580) et en raccord à la première série (580),
les éléments (110) de mise en contact des parties (122) de signaux de communication du troisième nombre (523) de raccordements de module (120, 130, 140, 145, 320, 680, 681, 682, 683, 684, 685) de la troisième série (585) étant raccordés de manière électriquement conductrice les uns aux autres par l'intermédiaire du support (160) de transfert de données,
les éléments (110) de mise en contact de la partie (122) de signaux de communication d'un dernier raccordement de module (584) mis en contact dans la deuxième série (582) étant raccordés de manière électriquement conductrice par l'intermédiaire du support (160) de transfert de données aux éléments (110) de mise en contact de la partie (122) de signaux de communication d'un premier raccordement de module (586) mis en contact dans la troisième série (587).

11. Unité de couplage (100, 200, 300, 400, 500, 600, 700, 800) selon l'une des revendications précédentes, dans laquelle la carte de bus (91, 92, 93, 94, 95, 96, 97, 98) comporte au moins une carte (301, 401) de raccordement de modules présentant le premier et le deuxième raccordement de module (120, 130, 140, 145, 320, 680, 681, 682, 683, 684, 685) et au moins une carte (302, 402) de raccordement de terrains présentant le premier et le deuxième raccordement de terrain (150, 360),
la ou les cartes (301, 401) de raccordement de modules et la ou les cartes (302, 402) de raccordement de terrains étant raccordées mutuellement de manière électriquement conductrice par l'intermédiaire d'un premier élément de liaison (330, 430, 530) et d'un deuxième élément de liaison (340, 440, 540),
les éléments (110) de mise en contact des parties (122) de signaux de terrain d'un premier groupe (321, 421, 422) de raccordements de module (120, 130, 140, 145, 320, 680, 681, 682, 683, 684, 685) étant raccordés de manière électriquement conductrice au premier élément de liaison (330, 430, 530) et
les éléments (110) de mise en contact des parties (122) de signaux de terrain d'un deuxième groupe (322, 423, 424) de raccordements de module (120, 130, 140, 145, 320, 680, 681, 682, 683, 684, 685) étant raccordés de manière électriquement conductrice au deuxième élément de liaison (340, 440, 540).

12. Système industriel de commande (1, 2, 3, 4, 5, 6, 7, 8) présentant
une unité de couplage (100, 200, 300, 400, 500, 600, 700, 800) selon l'une des revendications 1 à 11,
un premier module de commande (20, 22, 23, 350, 651, 652, 653) raccordé au premier raccordement de module (120, 320, 680, 681, 682, 683, 684, 685) de l'unité de couplage (100, 200, 300, 400, 500, 600, 700, 800),
un deuxième module de commande (22, 23, 350, 651, 652, 653) raccordé au deuxième raccordement de module (130, 320, 680, 681, 682, 683, 684, 685) de l'unité de couplage (100, 200, 300, 400, 500, 600, 700, 800),
un premier appareil de terrain (10) qui est raccordé par l'intermédiaire d'un premier support (15) de transfert de signaux de terrain rassemblé en faisceau au premier raccordement de terrain (150, 360) et
un deuxième appareil de terrain (12) qui est raccordé par l'intermédiaire d'un deuxième support (15) de transfert de signaux de terrain rassemblé en faisceau au deuxième raccordement de terrain (155, 360),
le système industriel de commande (1, 2, 3, 4, 5, 6, 7, 8) étant configuré pour transmettre les signaux de terrain du premier et du deuxième module de commande (20, 22, 23, 350, 651, 652, 683) par l'intermédiaire du support (170) de transfert de signaux, pour transmettre les signaux de terrain du premier raccordement de terrain (150, 360) et du premier support (15) de transfert de signaux de terrain au premier appareil de terrain (10) et pour transmettre des signaux de terrain du premier et du deuxième module de commande (20, 22, 23, 350, 651, 652, 653) par l'intermédiaire du support (170) de transfert de signaux, du deuxième raccordement de terrain (155, 360) et du deuxième support (15) de transfert de signaux de terrain au deuxième appareil de terrain (12).

13. Système industriel de commande (1, 2, 3, 4, 5, 6, 7, 8) selon la revendication 12, dans lequel l'unité de couplage (100, 200, 300, 400, 500, 600, 700, 800) présente
un raccordement (146, 246) de module de convertisseur,
un module de convertisseur (30, 32) doté d'une interface (31, 33) par rapport à un parcours de données (50) d'ordre hiérarchique plus élevé, le module de convertisseur (30, 32) étant configuré pour assurer le contact électrique d'éléments (110) de mise en contact du raccordement (146, 246) de module de convertisseur,
le module de convertisseur (30, 32) étant configuré pour transférer des données de communication entre l'interface (31, 33) par rapport au parcours de données (50) d'ordre hiérarchique plus élevé et des éléments (110) de mise en contact d'une partie (122) de signaux de communication du raccordement (146, 246) de module de convertisseur.

14. Système industriel de commande (1, 2, 3, 4, 5, 6, 7, 8) selon la revendication 13, dans lequel une partie du parcours de données (50) d'ordre hiérarchique plus élevé est disposée sur l'unité de couplage (100, 200, 300, 400, 500, 600, 700, 800), le parcours de données (50) d'ordre hiérarchique plus élevé assurant le contact électriquement conducteur avec les éléments (110) de mise en contact du raccordement (146, 246) de module de convertisseur.

15. Système industriel de commande (1, 2, 3, 4, 5, 6, 7, 8) selon l'une des revendications 12 à 14, dans lequel le module de convertisseur (30, 32), le premier et le deuxième module de commande (20, 22, 23, 350, 651, 652, 653) et le support (160) de transfert de données sont configurés de manière à transmettre les données de communication au moyen de télégrammes de données sur bus E, le module de convertisseur (30, 32) étant configuré pour transmettre les données de communication au moyen de télégrammes de données Ethernet, en particulier au moyen de télégrammes de données dits EtherCAT par l'intermédiaire du parcours de données (50) d'ordre hiérarchique plus élevé.
